# EUROPÄISCHE PATENTSCHRIFT

(11) **EP 2 742 390 B1**
(45) Veröffentlichungstag und Bekanntmachung des Hinweises auf die Patenterteilung: **09.09.2015**
(21) Anmeldenummer: 12743126.0
(22) Anmeldetag: 26.07.2012
(51) Int. Cl.: G05B 19/042, H01R 9/26, H05K 7/14

(54) **MODULARE STEUERUNGSVORRICHTUNG**
MODULAR CONTROL APPARATUS
DISPOSITIF MODULAIRE DE COMMANDE

(30) Priorität: 09.08.2011 DE 102011110183
(43) Veröffentlichungstag der Anmeldung: 18.06.2014
(73) Patentinhaber: Pilz GmbH & Co. KG, 73760 Ostfildern (DE)
(72) Erfinder: GRUBER, Winfried, 73760 Ostfildern (DE); STADLER, Hermann, 73760 Ostfildern (DE); HEWER, Patrick, 73760 Ostfildern (DE); WINKLER, Markus, 73760 Ostfildern (DE)
(74) Vertreter: Witte, Weller & Partner Patentanwälte mbB
(86) Internationale Anmeldenummer: PCT/EP2012/064682
(87) Internationale Veröffentlichungsnummer: WO 2013/020817

(56) Entgegenhaltungen:
- EP-A1- 1 764 873
- EP-A1- 2 009 522
- DE-A1- 19 651 961
- DE-A1- 19 651 962
- Anonymous: "PSSuniversal - Programmable control systems PSS - System Description - No. 21256-EN-04", , 1. Januar 2010 (2010-01-01), Seiten 1-89, XP55041267, Gefunden im Internet: URL:http://www.pilz.com/downloads/open/PSS universal_Sys_Descr_21256-EN-04.pdf [gefunden am 2012-10-17] in der Anmeldung erwähnt

## Beschreibung

Die vorliegende Erfindung betrifft eine Steuerungsvorrichtung zum automatisierten Steuern einer technischen Anlage nach dem Oberbegriff von Anspruch 1.

Eine Steuerungsvorrichtung dieser Art ist in DE 196 51 961 A1 beschrieben.

Eine weitere Steuerungsvorrichtung und ein Modul bzw. Modulteil dafür sind aus der Beschreibung, PSSuniversal, Programmable Control Systems PSS®, System Description, No. 21256-EN-04" der Anmelderin bekannt.

Eine Steuerungsvorrichtung im Sinne der vorliegenden Erfindung kann beispielsweise eine modulare Steuerungsvorrichtung für eine konfigurierbare oder programmierbare Steuerung sein. Es kann eine konfigurierbare Steuerung sein, wie beispielsweise jene, die die Anmelderin der vorliegenden Erfindung unter der Marke PNOZ® vertreibt, oder eine programmierbare Steuerung, wie beispielsweise jene, die die Anmelderin der vorliegenden Erfindung unter der Marke PSS® vertreibt, oder eine dieser ähnliche. Unter konfigurierbar ist hier das Anpassen oder Einstellen eines Hardwarebestandteils der Steuerung zu verstehen, wie beispielsweise einer Verdrahtung. Unter programmierbar ist hier das Anpassen oder Einstellen eines Softwarebestandteils der Steuerung zu verstehen, beispielsweise mittels einer Programmiersprache.

Insbesondere stellt PSSuniversal® eine modulare programmierbare Steuerungsvorrichtung für Standard- und Sicherheitsaufgaben bereit, wie aus der Beschreibung "Pilz, PSSuniversal, Programmable Control Systems PSS®, System Description, No. 21256-EN-04" bekannt. Ein Modul umfasst hier ein erstes Modulteil in Form eines Elektronikmodulteils und ein zweites Modulteil in Form eines Basismodulteils, oder im Folgenden auch Busmodulteil genannt. Das Elektronikmodulteil wird durch eine lineare Bewegung auf das Busmodulteil gesteckt.

Das Elektronikmodulteil hat in diesem System zwei verschiedene Bauformen. In einer ersten Bauform kann Elektronikmodulteil ein Ein-/Ausgabemodulteil sein (z.B. für Fail Safe(FS)- oder Standard(ST)-Anwendungen). In einer zweiten Bauform kann das Elektronikmodulteil ein Spannungsversorgungsmodulteil, oder auch Einspeisemodul genannt, sein zur Einspeisung eines Module Supply, d.h. einer internen Versorgungsspannung, oder zur Einspeisung eines Periphery Supply, d.h. einer externen Versorgungsspannung. Es können so mehrere Potenzialgruppen gebildet werden. Für die erste Bauform (Ein-/Ausgabemodulteil) wird ein entsprechendes Busmodulteil verwendet, das in beiden Richtungen (nach rechts und nach links) der Längsrichtung Busanschlüsse aufweist, um die Versorgungsspannung von dem links danebenliegenden Modul auf das rechts danebenliegende Modul durchzuschalten. Diese Bauart wird daher auch Bauart mit durchgeschaltetem Bus genannt. Für die zweite Bauform (Spannungsversorgungsmodulteil) wird ein entsprechendes Busmodulteil benötigt, das in eine erste Richtung (z.B. nach links) keine Verbindung zum Versorgungsspannungsbus aufweist und in die andere Richtung (z.B. nach rechts) eine Verbindung zum Versorgungsspannungsbus auf-weist, um die Versorgungsspannung nur an die rechts danebenliegenden Module weiterzuleiten. Das heißt, bei Bildung einer neuen Potenzialgruppe muss die Verbindung auf dem Versorgungsspannungsbus durch ein entsprechendes Busmodulteil aufgetrennt werden. Diese Bauform wird daher auch Bauform mit aufgetrenntem Bus genannt. Es müssen also zwei Bauformen des zweiten Modulteils (Busmodulteil) bereitgestellt werden, zum einen mit durchgeschaltetem Bus und zum anderen mit aufgetrenntem Bus.

Eine Steuerungsvorrichtung mit einem Modul mit drei Modulteilen ist beispielsweise durch das X20-System von B&R bekannt, wie aus der Beschreibung "X20-System, User's Manual, Version: 2.10 (May 2009), Model number: Marx20-ENG" ersichtlich. Ein Modul umfasst hier ein erstes Modulteil in Form eines Elektronikmodulteils, ein zweites Modulteil in Form eines Busmodulteils und ein drittes Modulteil in Form eines Feldklemmenmodulteils, oder auch Anschlussmodulteil genannt. Die externen Anschlüsse sind in diesem System in einem separaten Anschlussmodulteil untergebracht.

Auch in diesem System gibt es das Busmodulteil in zwei Bauformen: einer ersten Bauform mit durchverbundener Versorgung (bezeichnet mit X20BM11) und einer zweiten Bauform mit Auftrennung der Versorgung in eine Richtung (bezeichnet mit X20BM01). Letztere Bauform dient zur Verbindung mit entsprechenden Spannungsversorgungsmodulteilen. Dadurch können auch in diesem System verschiedene Potenzialgruppen gebildet werden.

Ein Problem solcher Steuerungsvorrichtungen ist, dass eine spezielle Bauform des Busmodulteils für ein entsprechendes Spannungsversorgungsmodulteil notwendig ist. Dies erhöht zum einen die Herstellungskosten und zum anderen kann es für den Benutzer kompliziert sein, die passende Bauformen der Modulteile korrekt zusammenzusetzen.

EP 2 009 522 A1 offenbart ein Periphericsystem mit einer Vielzahl von nebeneinander angeordneten Peripheriemodulen. Ferner ist ein Peripheriemodul offenbart mit einer Klemme zum Anlegen einer Versorgungsspannung und zum unmittelbaren Einspeisen der Versorgungsspannung in eine durch das Peripheriesystem verlaufende, selbstaufbauende Potentialschiene. Das Peripheriemodul verfügt zusätzlich über eine Umschaltvorrichtung, mit der die Potentialschiene am Ort des Peripheriemoduls auftrennen lässt, um die folgenden Peripheriemodule von den vorgelagerten Lastgruppen zu trennen.

Die eingangs genannte DE 196 51 961 A1 offenbart ein Steuergerät mit nebeneinander angeordneten Modulen, wobei diese Module modular aufgebaut sind und einen Sockelteil, ein Elektronikmodul und eine Anschlussvorrichtung umfassen. Die Module sind über Potentialkontakte in den Sockelteilen, die nebeneinander angeordnet eine Potentialkontaktkette bilden, mit einander verbunden. Darüber hinaus offenbart DE 196 51 961 A1 einen separaten Potenzialeinspeisestecker, über den an den Potentialkontakten der Sockelleisten eine Spannung an die Potentialkontaktkette angelegt werden kann. Ferner kann durch den Potentialeinspeisestecker die Potentialkontaktkette an der Stelle der Einspeisung aufgetrennt werden.

Vor diesem Hintergrund ist es eine Aufgabe der vorliegenden Erfindung, eine Steuerungsvorrichtung und ein Modul bzw. Modulteil der eingangs genannten Art anzugeben, die geringere Herstellungskosten und/oder eine erhöhte Benutzerfreundlichkeit bereitstellen.

Die Aufgabe wird durch die Steuerungsvorrichtung nach Anspruch 1 gelöst.

Die neue Steuerungsvorrichtung ermöglicht, dass in der ersten Position des beweglichen Teils eine an einem der Busanschlüsse anliegende Spannung zwischen dem ersten und zweiten Busanschluss durchgeschaltet wird, und in der zweiten Position des beweglichen Teils eine galvanische Trennung zwischen dem ersten und dem zweiten Busanschluss bereitgestellt wird. Anstelle von zwei unterschiedlichen Bauformen des Modulteils (eine Bauform mit durchgeschaltetem Bus und eine Bauform mit aufgetrenntem Bus) wird hier also nur eine einzige Bauform des Modulteils (auch Busmodulteil genannt) benötigt, was geringere Herstellungskosten und erhöhte Benutzerfreundlichkeit ermöglicht.

Das erste Modulteil und das zweite Modulteil können mechanisch und elektrisch in eine erste zusammengesetzte Anordnung zusammen gesetzt werden. Das erste Modulteil umfasst zumindest einen ersten elektrischen Kontakt. Das zweite Modulteil umfasst zumindest einen ersten elektrischen Gegenkontakt, der in der ersten zusammengesetzten Anordnung den ersten elektrischen Kontakt kontaktiert zur elektrische Verbindung zwischen dem ersten und dem zweiten Modulteil.

Damit wird eine Modularität des Moduls bereitgestellt. Es können so den einzelnen Modulteilen unterschiedliche Funktionen zugewiesen werden.

Das zweite Modulteil weist einen ersten Kontaktpunkt auf, der mit dem ersten Busanschluss elektrisch verbunden ist, und einen zweiten Kontaktpunkt auf, der mit dem zweiten Busanschluss elektrisch verbunden ist. Die Isolierstelle befindet sich zwischen dem ersten Kontaktpunkt und dem zweiten Kontaktpunkt, wenn das bewegliche Teil in der zweiten Position ist. Damit wird eine einfache Realisierung der Isolierstelle bereitgestellt. Die Isolierstelle wird zwischen zwei Kontaktpunkten gebildet.

Ferner ist der elektrische Gegenkontakt einer der Kontaktpunkte, so dass in der ersten zusammengesetzten Anordnung der erste elektrische Kontakt den einen Kontaktpunkt des zweiten Modulteils zur elektrischen Verbindung zwischen dem ersten und zweiten Modulteil kontaktiert, wenn das bewegliche Teil in der zweiten Position ist, um einen Einspeiseanschluss bereitzustellen.

Damit wird das Zuführen einer Spannung, insbesondere Versorgungsspannung, von dem ersten Modulteil zu dem zweiten Modulteil ermöglicht. Diese eingespeiste Spannung kann dann zu dem einen Busanschluss geführt werden, nicht jedoch zu dem anderen. Es wird so ermöglicht, dass das erste Modulteil in Form eines Versorgungsspannungsmodulteils (oder Einspeisemodulteils) mit dem zweiten Modulteil (Busmodulteil) verbunden werden kann, um von dem ersten Modulteil zu dem zweiten Modulteil eine Versorgungsspannung zuzuführen bzw. einzuspeisen.

In einer Ausgestaltung umfasst das erste Modulteil eine Signalverarbeitungseinheit. Somit wird dem ersten Modulteil die Funktion eines Elektronikmodulteils zugewiesen und dem zweiten Busmodulteil wird die Funktion eines Busmodulteils zugewiesen.

In einer weiteren Ausgestaltung weist zumindest eines der ersten Modulteile eine Grundbreite in Längsrichtung auf und das zweite Modulteil weist eine Breite in Längsrichtung auf, die ein ganzzahliges Vielfaches der Grundbreite ist.

In dieser Ausgestaltung wird eine Granularität einer durch die zweiten Modulteile gebildeten sogenannten Backplane bereitgestellt. Es werden hier weniger zweite Modulteile benötigt verglichen mit der Verwendung von ausschließlich zweiten Modulteilen einer der Grundbreite entsprechenden Breite. Das zweite Modulteil kann so beispielsweise in zwei Breitenformen mit unterschiedlichen Breiten bereitgestellt werden. In einer Breitenform mit der Grundbreite und in einer zweiten Breitenform in einer Breite, die ein ganzzahliges Vielfaches der Grundbreite ist. Das ganzzahlige Vielfache kann insbesondere ein gradzahliges Vielfaches sein.

In einer weiteren Ausgestaltung umfasst das zweite Modulteil (in der zweiten Breitenform) eine der ganzen Zahl entsprechende Anzahl von beweglichen Teilen, die jeweils in die erste Position und die zweite Position beweglich sind. Jedes der beweglichen Teile umfasst eine elektrische Leitung, die derart angeordnet ist, dass durch die elektrischen Leitungen eine elektrische Verbindung zwischen dem ersten Busanschluss und dem zweiten Busanschluss bereitgestellt wird, wenn jedes der beweglichen Teile in der ersten Position ist. Jedes der beweglichen Teile in seiner zweiten Position stellt eine Isolierstelle zwischen dem ersten Busanschluss und dem zweiten Busanschluss bereit.

In dieser Ausgestaltung ist frei wählbar, wo und wie viele erste Modulteile auf ein zweites Modulteil aufgesetzt werden. Ist ein entsprechendes bewegliches Teil in der ersten Position, so wird der Bus an dieser Stelle durchgeschaltet. Es muss hier kein erstes Modulteil aufgesetzt werden. Ist jedoch ein entsprechendes bewegliches Teil in der zweiten Position, so ist an dieser Stelle der Bus aufgetrennt und ein entsprechendes erstes Modulteil (Elektronikmodulteil bzw. Einspeisemodulteil) wird aufgesetzt.

In einer weiteren Ausgestaltung weist mindestens ein anderes der ersten Modulteile eine Breite in Längsrichtung auf, die ein ganzzahliges Vielfaches der Grundbreite ist.

In dieser Ausgestaltung wird das erste Modulteil in zwei Breitenformen mit zwei unterschiedlichen Breiten bereitgestellt. In einer ersten Breitenform mit der Grundbreite und in einer zweiten Breitenform mit einer Breite, die ein ganzzahliges Vielfaches der Grundbreite ist. In der zweiten Breitenform kann das erste Modulteil über eine Trennstelle zwischen zwei nebeneinanderliegenden zweiten Modulteilen hinweg angeordnet werden Das ganzzahlige Vielfache kann insbesondere ein gradzahliges Vielfaches sein.

In einer weiteren Ausgestaltung ist der weitere elektrische Kontakt des ersten Modulteils gegenüber dem anderen Kontaktpunkt des zweiten Modulteils isoliert.

In dieser Ausgestaltung wird sichergestellt, dass die eingespeiste (Versorgungs-)Spannung nur zu dem einen Anschluss, nicht jedoch zu dem anderen Busanschluss geführt wird. Das heißt, die Versorgungsspannung kann nur in einer Richtung auf dem Bus weitergeleitet werden, beispielsweise nur nach rechts oder nur nach links. Es ist daher ein Einspeisen einer neuen oder weiteren Spannung möglich, so dass eine neue oder weitere Potenzialgruppe gebildet werden kann.

In einer weiteren Ausgestaltung umfasst das bewegliche Teil zumindest eine elektrische Leitung, die derart angeordnet ist, dass durch die elektrische Leitung eine elektrische Verbindung zwischen dem ersten Kontaktpunkt und dem zweiten Kontaktpunkt und/oder zwischen dem ersten Busanschluss und dem zweiten Busanschluss bereitgestellt wird, wenn das bewegliche Teil in der ersten Position ist.

Durch diese Ausgestaltung wird ein Durchschalten der Spannung zwischen dem ersten und dem zweiten Busanschluss ermöglicht.

In einer weiteren Ausgestaltung ist die Isolierstelle ein luftgefüllter Bereich, wenn das bewegliche Teil in der zweiten Position ist.

In dieser Ausgestaltung wird eine einfache und daher kostengünstige Art der Unterbrechung bzw. Auftrennung bereitgestellt. Alternativ kann die Isolierstelle auch auf andere geeignete Art gebildet werden. Beispielsweise kann ein isolierendes Material in der Isolierstelle angeordnet sein.

In einer weiteren Ausgestaltung ist das bewegliche Teil ein auf einer Führung geführtes Schiebeelement, das zwischen der ersten und der zweiten Position verschiebbar ist.

In dieser Ausgestaltung wird eine einfache und daher kostengünstige Realisierung des beweglichen Teils bereitgestellt. Das Schiebeelement kann beispielsweise linear zwischen der ersten und zweiten Position verschiebbar sein, insbesondere parallel zu der Grenzfläche oder Backplane. Alternativ kann das Schiebeelement Beispielsweise winkelförmig um einen definierten Drehpunkt zwischen der ersten und zweiten Position verschiebbar bzw. drehbar sein.

In einer alternativen Ausgestaltung ist das bewegliche Teil ein Jumper, der in der ersten Position in die Isolierstelle eingesetzt werden kann oder eingesetzt ist und in der zweiten Position von der Steuerungsvorrichtung abgenommen werden kann oder abgenommen ist.

In dieser Ausgestaltung wird eine einfache und daher kostengünstige Realisierung des beweglichen Teils bereitgestellt. Unter einem Jumper ist hier ein separates, komplett abnehmbares Bauteil mit einer elektrischen Leitung zu verstehen. Beispielsweise kann ein Steckplatz in der Nähe der Isolierstelle vorgesehen sein, in den der Jumper in der zweiten (abgenommenen) Position eingesetzt werden kann bzw. darin aufbewahrt werden kann.

In einer weiteren Ausgestaltung weist das erste Modulteil zwei redundante Signalverarbeitungskanäle auf, um zumindest ein Eingangssignal redundant zueinander zu verarbeiten. Die zwei redundanten Signalverarbeitungskanäle können jeweils in der Lage sein, logische Signalverknüpfungen vorzunehmen, um in Abhängigkeit davon ein Signal zu erzeugen. Dieses Signal kann bevorzugt verwendet werden, um ein Schaltelement zum Abschalten der technischen Anlage anzusteuern. Das zumindest eine Eingangssignal kann ein Signal sein, das an dem externen Anschluss des dritten Modulteils anliegt. Bevorzugt verarbeiten die zwei Signalverarbeitungskanäle zwei Eingangssignale redundant zueinander. Jedes der zwei Eingangssignale kann dann ein Signal sein, das an jeweils einem externen Anschluss des dritten Modulteils anliegt.

In dieser Ausgestaltung führt das entsprechende Modul bzw. Modulteil Sicherheitsaufgaben oder Sicherheitsfunktionen aus. Insbesondere kann hier das entsprechende Modul bzw. Modulteil zum fehlersicheren (FS) Abschalten der technischen Anlage verwendet werden.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine vereinfachte Darstellung einer technischen Anlage mit einem Ausführungsbeispiel der Steuerungsvorrichtung,
- Fig. 2: eine perspektivische Darstellung eines Ausführungsbeispiels der Steuervorrichtung mit mehreren nebeneinander angeordneten Modulen mit ersten Modulteilen und zweite Modulteilen,
- Fig. 3: eine perspektivische Darstellung des Ausführungsbeispiels der Steuervorrichtung nach Fig. 2 mit nur zweiten Modulteilen,
- Fig. 4: eine perspektivische Darstellung eines ersten Ausführungsbeispiels eines Moduls mit einem ersten, zweiten und dritten Modulteil in einer ersten und zweiten zusammengesetzten Anordnung,
- Fig. 4a: eine Querschnittsansicht des in Fig. 4 gezeigten Moduls,
- Fig. 5: eine perspektivische Darstellung des ersten Ausführungsbeispiels des Moduls der Fig. 4 in einem Zustand, in dem das dritte Modulteil gelöst wird,
- Fig. 5a: eine Querschnittsansicht des in Fig. 5 gezeigten Moduls,
- Fig. 6: eine perspektivische Darstellung des ersten Ausführungsbeispiels des Moduls der Fig. 4 bis 5 in einem Zustand, in dem das erste Modulteil in der ersten zusammengesetzten Anordnung lösbar ist,
- Fig. 6a: eine Querschnittsansicht des in Fig. 6 gezeigten Moduls,
- Fig. 7: eine perspektivische Darstellung des ersten Ausführungsbeispiels des Moduls der Fig. 4 bis 6 in einem Zustand, in dem das erste Modulteil gelöst wird,
- Fig. 7a: eine Querschnittsansicht des in Fig. 7 gezeigten Moduls,
- Fig. 8: eine perspektivische Darstellung eines zweiten Ausführungsbeispiels eines Moduls mit einem ersten, zweiten und dritten Modulteil in einer ersten und zweiten zusammengesetzten Anordnung,
- Fig. 8a: eine Querschnittsansicht des in Fig. 8 gezeigten Moduls,
- Fig. 8b: einen vergrößerten Bereich X der Querschnittsansicht der Fig. 8a,
- Fig. 9-11: jeweils eine perspektivische Darstellung eines weiteren Ausführungsbeispiels eines Moduls mit ersten und zweiten Modulteilen,
- Fig. 11a: eine perspektivische Ansicht des ersten Modulteils der Fig. 11,
- Fig. 12: eine perspektivische Ansicht eines Ausführungsbeispiels des zweiten Modulteils, insbesondere des zweiten Modulteils der Fig. 2 und 3,
- Fig. 13: eine Draufsicht von oben auf das zweite Modulteil der Fig. 12,
- Fig. 14: eine perspektivische Innenansicht des zweiten Modulteils der Fig. 12 und 13, und
- Fig. 14a: einen vergrößerten Bereich X der perspektivischen Innenansicht der Fig. 14.

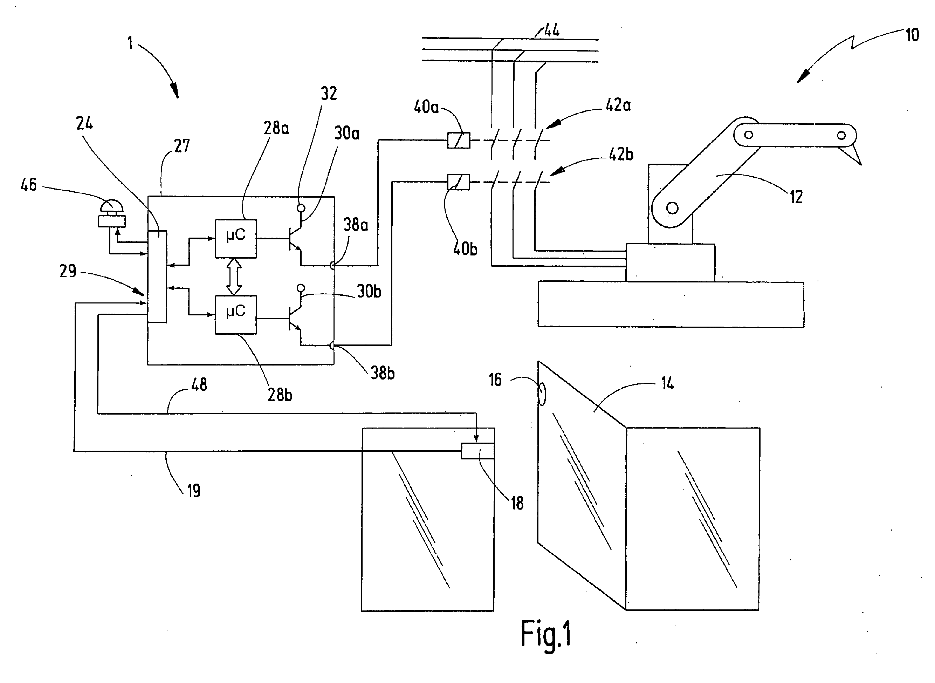

In Fig. 1 ist eine technische Anlage 10 mit einem Ausführungsbeispiel der neuen Steuerungsvorrichtung 1 zum automatisierten Steuern der technischen Anlage 10 dargestellt. In diesem Ausführungsbeispiel ist die Steuerungsvorrichtung 1 geeignet zum fehlersicheren Abschalten der Anlage 10, d.h. die Steuerungsvorrichtung 1 wird für Sicherheitsaufgaben verwendet. Die Anlage 10 beinhaltet hier beispielhaft einen Roboter 12, von dessen Bewegungen im Arbeitsbetrieb eine Gefahr für Personen ausgeht, die sich im Arbeitsbereich des Roboters 12 aufhalten. Aus diesem Grund ist der Arbeitsbereich des Roboters 12 mit einem Schutzzaun mit einer Schutztür 14 abgesichert. Die Schutztür 14 ermöglicht den Zugang in den Arbeitsbereich des Roboters 12, beispielsweise für Wartungsarbeiten oder für Einrichtarbeiten. Im normalen Arbeitsbetrieb darf der Roboter 12 jedoch nur arbeiten, wenn die Schutztür 14 geschlossen ist. Sobald die Schutztür 14 geöffnet wird, muss der Roboter 12 abgeschaltet werden oder auf andere Weise in einen sicheren Zustand gebracht werden.

Um den geschlossenen Zustand der Schutztür 14 zu detektieren, ist an der Schutztür 14 ein Schutztürschalter mit einem Türteil 16 und einem Rahmenteil 18 angebracht. Das Rahmenteil 18 erzeugt auf einer Leitung 20 ein Schutztürsignal, das über die Leitung 20 der neuen Steuerungsvorrichtung 1 zugeführt ist.

Die Steuerungsvorrichtung 1 besitzt in diesem Ausführungsbeispiel einen E/A-Teil 24 mit einer Vielzahl von Anschlüssen (bzw. externen oder Geräteanschlüssen) 29. In einigen Ausführungsbeispielen sind die Anschlüsse 29 Anschlussklemmen oder Feldklemmen, die an einer Gehäuseseite des Gehäuses 27 der Steuerungsvorrichtung 1 angeordnet sind, beispielsweise an einem Anschlussmodulteil, wie im Folgenden erklärt werden wird. Beispielsweise kann es sich um Federzugklemmen oder um Schraubklemmen handeln. In anderen Ausführungsbeispielen können die Anschlüsse Stecker oder Buchsen sein, die mehrere Kontaktelemente (Pins) beinhalten, wobei jeweils ein Pin einen Anschluss bildet. Häufig werden M8-Buchsen mit fünf Kontaktpins für den Anschluss von Meldegeräten oder anderen Sensoren auf Feldebene verwendet. Dementsprechend können Ausführungsbeispiele der neuen Steuerungsvorrichtung Feldgeräte sein oder umfassen, die außerhalb eines Schaltschranks in räumliche Nähe zu dem Roboter 12 angeordnet sind.

Die Steuerungsvorrichtung 1 besitzt in diesem Ausführungsbeispiel zwei redundante Signalverarbeitungskanäle. Beispielhaft sind hier zwei Mikrokontroller 28a, 28b dargestellt, die jeweils mit dem E/A-Teil 24 verbunden sind. Die Mikrokontroller 28a, 28b verarbeiten hier redundant zueinander die Eingangssignale, die das Steuerungsvorrichtung 1 an den Geräteanschlüssen des E/A-Teils 24 aufnimmt, und sie vergleichen ihre Ergebnisse, was mit einem Pfeil 29 dargestellt ist. Anstelle von zwei Mikrokontrollern 28a, 28b können Mikroprozessoren, ASICs, FPGAs und/oder andere Signalverarbeitungsschaltkreise verwendet sein. Bevorzugt besitzen Ausführungsbeispiele der Steuerungsvorrichtung 1 zumindest zwei zueinander redundante Signalverarbeitungskanäle, die jeweils in der Lage sind, logische Signalverknüpfungen vorzunehmen, um in Abhängigkeit davon ein Signal zu erzeugen. Dieses Signal wird dann verwendet, um ein Schaltelement zum Abschalten des Roboters 12 anzusteuern. Eine solche Steuerungsvorrichtung 1 kann dann zum fehlersicheren (FS) Abschalten der Anlage 10, hier des Roboters 12, verwendet werden.

In dem hier dargestellten Fall besitzt die Steuerungsvorrichtung 1 zwei redundante Schaltelemente 30a, 30b. Jedes dieser beiden Schaltelemente ist in der Lage, ein hohes Spannungspotential 32 zu einem Geräteanschluss 38a, 38b der Steuervorrichtung 1 durchzuschalten, um einen Stromfluss zu einem Schütz 40a, 40b zu ermöglichen, oder diesen Stromfluss zu unterbrechen. Damit kann jedes der Schaltelemente 30 einen Aktor, wie einen Schütz oder ein Magnetventil, abschalten.

Die Schütze 40a, 40b besitzen jeweils Arbeitskontakte 42a, 42b. Die Arbeitskontakte 42a, 42b sind hier in Reihe zueinander in einen Stromversorgungspfad von einer Stromversorgung 44 zu dem Roboter 12 angeordnet. Sobald die Steuervorrichtung 1 die Schütze 40a, 40b abschaltet, fallen die Kontakte 42 ab und die Stromversorgung für den Roboter 12 wird abgeschaltet. Den einschlägigen Fachleuten ist klar, dass eine solche "radikale" Abschaltung hier beispielhaft beschrieben ist. Abweichend hiervon können bei einer Sicherheitsanforderung lediglich Teile des Roboters 12 abgeschaltet werden, wie etwa die gefährlichen Antriebe, während andere Teile des Roboters 12 funktionsbereit bleiben. Auch ein verzögertes Abschalten ist denkbar, damit der Roboter 12 ggf. vor dem Abschalten der Antriebe kontrolliert abgebremst werden kann.

Die Steuervorrichtung 1 steuert die Schaltelemente 30a, 30b hier in Abhängigkeit von dem Signal des Schutztürschalters auf der Leitung 19 und in Abhängigkeit von einem weiteren Eingangssignal von einem Not-Aus-Taster 46 an. Auch der Not-Aus-Taster 46 ist über Leitungen mit Geräteanschlüssen der Steuervorrichtung 1 verbunden. Bevorzugt kann jedes der Eingangssignale redundant anliegen bzw. es können jeweils zwei Eingangs- und Ausgangsleitungen oder Anschlüsse vorgesehen sein (in Fig. 1 nicht dargestellt). In dem in Fig. 1 gezeigten Beispiel können also für den Not-Aus-Taster 46 zwei Eingangsleitungen oder Eingänge vorgesehen sein, die jeweils ein Eingangssignal von dem Not-Aus- Taster 46 liefern. Ähnliches gilt für das Signal des Schutztürschalters.

In einigen Ausführungsbeispielen erzeugt die Steuervorrichtung 1 Ausgangssignale, die den einzelnen Meldegeräten zugeführt sind. Beispielhaft ist ein solches Ausgangssignal über eine Leitung 48 zu dem Rahmenteil 18 des Schutztürschalters geführt. Das Rahmenteil 18 schleift das Ausgangssignal des Sicherheitsschaltgerätes 1 von der Leitung 48 auf die Leitung 19, wenn sich das Türteil 16 in der Nähe des Rahmenteils 18 befindet, das heißt wenn die Schutztür 14 geschlossen ist. Daher kann die Steuervorrichtung 1 den Schutztürschalter mit Hilfe des Ausgangssignals auf der Leitung 48 und mit Hilfe des Eingangssignals auf der Leitung 19 überwachen. In vergleichbarer Weise überwacht die Steuervorrichtung 1 hier den Not-Aus-Taster 46.

Abweichend von der Darstellung in Fig. 1 werden in der Praxis häufig zwei redundante Ausgangssignale der Steuervorrichtung 1 verwendet, die jeweils über eine separate Signalleitung zu einem Meldegerät geführt sind und über dieses Meldegerät zurück zur Steuervorrichtung 1 geschleift sind. Beispielhaft für eine solche Realisierung sei auf DE 10 2004 020 995 A1 verwiesen, die hinsichtlich der Details einer solchen redundanten Überwachung eines Meldegerätes durch Bezugnahme aufgenommen ist. Auch der Not-Aus-Taster 46 wird in der Praxis häufig mit redundanten Eingangs- und Ausgangsleitungen überwacht, wie oben erwähnt.

In dem in Fig. 1 dargestellten Ausführungsbeispiel der Steuerungsvorrichtung 1 wird die Steuerungsvorrichtung für Sicherheitsaufgaben verwendet, insbesondere zum fehlersicheren (FS) Abschalten einer Anlage. Die Steuerungsvorrichtung 1 kann jedoch auch für nicht-sicherheitsgerichtete Aufgaben bzw. Standardaufgaben (ST) verwendet werden.

Die Steuerungsvorrichtung 1 kann insbesondere eine programmierbare Steuerungsvorrichtung für eine programmierbare Steuerung der technischen Anlage sein. Alternativ kann die Steuervorrichtung 1 auch eine konfigurierbare Steuerungsvorrichtung sein. Unter konfigurierbar ist hier das Anpassen oder Einstellen eines Hardwarebestandteils der Steuerung zu verstehen, wie beispielsweise einer Verdrahtung. Unter programmierbar ist hier das Anpassen oder Einstellen eines Softwarebestandteils der Steuerung zu verstehen, beispielsweise mittels einer Programmiersprache.

Die Steuervorrichtung 1 kann zumindest einen Bus umfassen, insbesondere einen Kommunikationsbus und/oder Versorgungsspannungsbus. Beispielsweise kann die Steuerungsvorrichtung 1 eine dezentrale Steuerungsvorrichtung sein, deren Komponenten über einen Bus miteinander verbunden sind. Die Steuerungsvorrichtung kann insbesondere ein Kopfmodul umfassen zur Koordination des Datenverkehrs auf dem (Kommunikations-)Bus. Bei einer Steuerungsvorrichtung 1 für Sicherheitsaufgaben kann der (Kommunikations-)Bus beispielsweise ein fehlersicherer Bus wie SafetyBUS p oder PROFINET sein. Bei einer Steuerungsvorrichtung 1 für Standardaufgaben kann der Bus beispielsweise ein Standardfeldbus wie CANOpen oder DeviceNet oder Ähnliches sein.

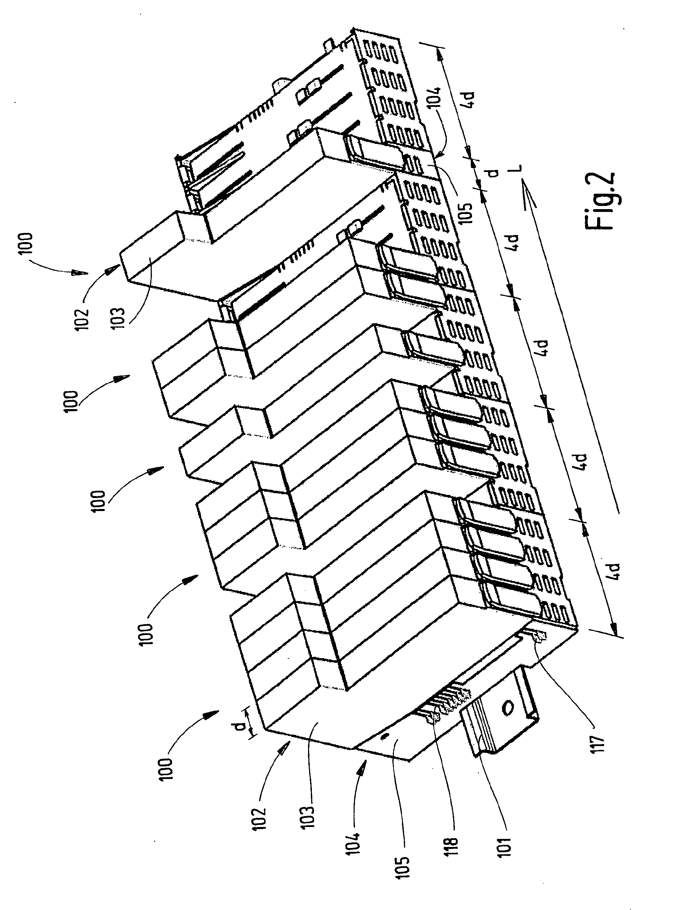

Die Steuerungsvorrichtung 1 ist insbesondere eine modulare Steuerungsvorrichtung mit zumindest einem Modul. Fig. 2 zeigt eine perspektivische Darstellung eines Ausführungsbeispiels der modularen Steuerungsvorrichtung mit mehreren nebeneinander angeordneten Modulen 100 mit ersten Modulteilen 102 und zweiten Modulteilen 104. Dritte Modulteile 106 sind in Fig. 2 nicht dargestellt. Das erste Modulteil 102 umfasst ein Gehäuse 103. Das zweite Modulteil 104 umfasst ein Gehäuse 105. Das zweite Modulteil 104 umfasst zumindest einen Busanschluss 117, 118. Das zweite Modulteil 104 wird daher im Folgenden auch Busmodulteil genannt.

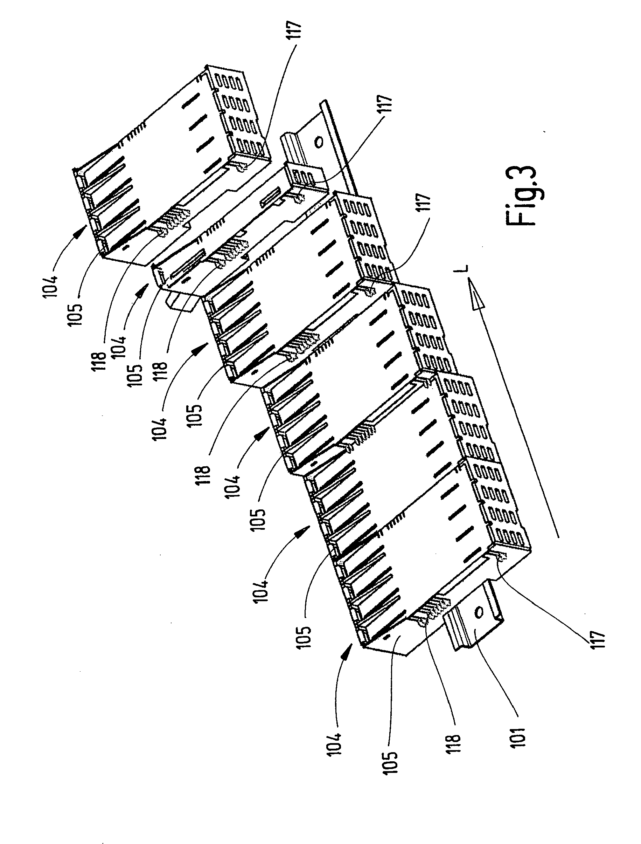

Fig. 3 zeigt eine perspektivische Darstellung des Ausführungsbeispiels der Steuervorrichtung nach Fig. 2 mit nur den zweiten Modulteilen (Busmodulteile) 104. Die zweiten Modulteile (Busmodulteile) 104 bzw. die Module 100 sind in einer Längsrichtung L nebeneinander angeordnet. Die zweiten Modulteile 104 bzw. die Module 100 werden, wie in Fig. 3 gezeigt, auf einer Führungsschiene 101 montiert. Das zweite Modulteil (Busmodulteil) 104 weist einen Busanschluss 117 für einen Versorgungsspannungsbus und einen Busanschluss 118 für einen Kommunikationsbus auf. Das zweite Modulteil (Busmodulteil) 104 umfasst einen ersten elektrischen Busanschluss 117, 118 an einer ersten Seite des Gehäuses 105 zur elektrischen Verbindung mit einem in Längsrichtung L danebenliegenden Nachbarmodulteil (in Fig. 2 und 3 einem rechts danebenliegenden Nachbarmodulteil). Das zweite Modulteil (Busmodulteil) 104 umfasst weiterhin einen zweiten elektrischen Busanschluss 117', 118' (in Fig. 3 nicht zu sehen) an einer zweiten, der ersten Seite gegenüberliegenden Seite des Gehäuses 105 zur elektrischen Verbindung mit einem in Längsrichtung L danebenliegenden anderen Nachbarmodulteil (in Fig. 2 und Fig. 3 einem links danebenliegenden Nachbarmodulteil). Insbesondere kann der zweite elektrische Busanschluss 117', 118' mit dem entsprechenden ersten elektrischen Busanschluss 117, 118 des anderen Nachbarmodulteils verbunden werden. Auf diese Weise wird der Versorgungsspannungsbus und der Kommunikationsbus über die zweiten Modulteile (Busmodulteile) 104 hinweg durchgeschaltet.

Die Steuerungsvorrichtung 1 kann weiterhin ein Kopfmodul (in Fig. 2 und Fig. 3 nicht dargestellt) umfassen, das Schnittstellen und ein Verarbeitungsteil umfasst, insbesondere zur Koordination des Datenverkehrs auf dem (Kommunikations-)Bus wie zuvor beschrieben. Das Kopfmodul kann dann ebenfalls auf der Führungsschiene 101 montiert sein bzw. werden. Das Kopfmodul kann in Längsrichtung L neben den zweiten Modulteilen (Busmodulteile) 104 bzw. Modulen 100, wie oben beschrieben, angeordnet sein. In Fig. 2 und Fig. 3 kann das Kopfmodul beispielsweise links neben dem in Längsrichtung L ersten Modul 100 angeordnet sein und über den ersten Busanschluss 117, 118 mit den Modulen verbunden sein. Jedes Modul 100, bzw. das entsprechende erste Modulteil (Elektronikmodulteil) 102, kann ein E/A(Ein/Ausgabe)-Modul bzw. Modulteil sein. Das E/A-Modul bzw. Modulteil kann ein fehlersicheres Modul (Fail-safe bzw. FS) oder ein nicht-fehlersicheres Standardmodul (ST) sein. Beispielhaft für eine solche Realisierung sei auf WO 2005/003869 A1 verweisen, die hinsichtlich Details einer solchen modularen Steuerungsvorrichtung durch Bezugnahme aufgenommen ist.

Wie in Fig. 3 ersichtlich wird durch die nebeneinanderliegenden zweiten Modulteile (Busmodulteile) 104 eine sogenannte Backplane bereitgestellt. Auf dieser Backplane können dann erste Modulteile 102 frei wählbar angeordnet werden. Die Die Backplane bildet hier insbesondere eine im Wesentlichen ebene Fläche. Eine fortlaufende Aneinanderreihung von ersten Modulteilen (Elektronikmodulteilen) 102 auf der Backplane ist nicht zwingend notwendig. Wie in Fig. 2 zu sehen, muss auf einem bestimmten zweiten Modulteil (Busmodulteil) 104, bzw. einem bestimmten Abschnitt einer Grundbreite d eines zweiten Busmodulteils (Busmodulteil) 104, nicht zwingend ein erstes Modulteil (Elektronikmodulteil) 102 angeordnet sein.

Wieder Bezug nehmend auf Fig. 2 kann auf ein jeweils zweites Modulteil 104 (Busmodulteil) zumindest ein erstes Modulteil 102 aufgesteckt wenden. Bevorzugt umfasst das erste Modulteil 102 eine elektrische Steuerungsschaltung zum automatisierten Steuern, beispielsweise mit einer oder mehreren Verarbeitungseinheiten, wie in Bezug auf Fig. 1 erklärt. Das erste Modulteil 102 wird im Folgenden auch Elektronikmodulteil genannt. Das erste Modulteil 102 (Elektronikmodulteil) und das zweite Modulteil 104 (Busmodulteil) können mechanisch und elektrisch in eine erste zusammengesetzte Anordnung zusammengesetzt werden, wie in Fig. 2 gezeigt. Durch diesen modularen Aufbau der Steuerungsvorrichtung 1 ist die Reaktion auf Änderungen und Anpassungen ohne größeren Aufwand möglich.

In dem in Fig. 2 und Fig. 3 dargestellten Ausführungsbeispiel wird das zweite Modulteil (Busmodulteil) 104 in mehreren Breitenformen bereitgestellt. Das erste Modulteil (Elektronikmodulteil) 102 hat eine Grundbreite d in Längsrichtung L. Einige der zweiten Modulteile 104 (Busmodulteil) haben jeweils eine Breite in Längsrichtung L, die ein ganzzahliges Vielfaches (n-faches) der Grundbreite d ist, insbesondere hier eine Breite, die ein Vierfaches der Grundbreite d ist (in Fig. 2 und Fig. 3 mit 4d bezeichnet). In diesem Fall ist das ganzzahlige Vielfache also ein gradzahliges Vielfaches, nämlich 4. Die Vierfache Grundbreite hat sich als besonders geeignet erwiesen für das Zusammensetzen einer größeren Backplane. Es kann jedoch auch jedes andere geeignete ganzzahlige Vielfache gewählt werden.

Wie in dem Ausführungsbeispiel der Fig. 2 und Fig. 3 zu sehen, hat ein anderes zweites Modulteil (Busmodulteil) 104 eine Breite, die der Grundbreite d entspricht. Das zweite Modulteil (Busmodulteil) wird also in zwei Breitenformen mit unterschiedlichen Breiten bereitgestellt. In einer ersten Breitenform mit der Grundbreite d und in einer zweiten Breitenform mit einer Breite 4d, die ein Vierfaches der Grundbreite d ist. Die Backplane kann so durch Anordnen nebeneinanderliegender zweiter Modulteile (Busmodulteile) der ersten und/oder zweiten Breitenform frei wählbar zusammengestellt werden. Durch Vorsehen von zweiten Modulteilen (Busmodulteile) 104 einer Breite, die ein ganzzahliges Vielfaches der Grundbreite d ist, werden weniger zweite Modulteile 104 benötigt, verglichen mit der Verwendung von ausschließlich zweiten Modulteilen 104 der Grundbreite d.

In dem in Fig. 2 dargestellten Ausführungsbeispiel haben alle ersten Modulteilen (Elektronikmodulteile) 102 die Grundbreite d in Längsrichtung L. Es können jedoch auch andere erste Modulteile 102 bereitgestellt werden, die eine Breite in Längsrichtung L haben, die ein ganzzahliges Vielfaches der Grundbreite d (m-faches) ist, insbesondere ein gradzahliges Vielfaches (z.B. 2-faches). Beispielsweise können andere erste Modulteile eine Breite in Längsrichtung aufweisen, die ein Zweifaches der Grundbreite d ist. Das erste Modulteil (Elektronikmodulteil) wird so in zwei Breitenformen mit zwei unterschiedlichen Breiten bereitgestellt. In einer ersten Breitenform mit der Grundbreite d und in einer zweiten Breitenform mit einer Breite, die ein ganzzahliges Vielfaches (m-faches) der Grundbreite d ist. Das erste Modulteil in der zweiten Breitenform kann dann über eine Trennstelle zwischen zwei nebeneinanderliegenden zweiten Modulteilen (Busmodulteilen) 104 hinweg angeordnet werden.

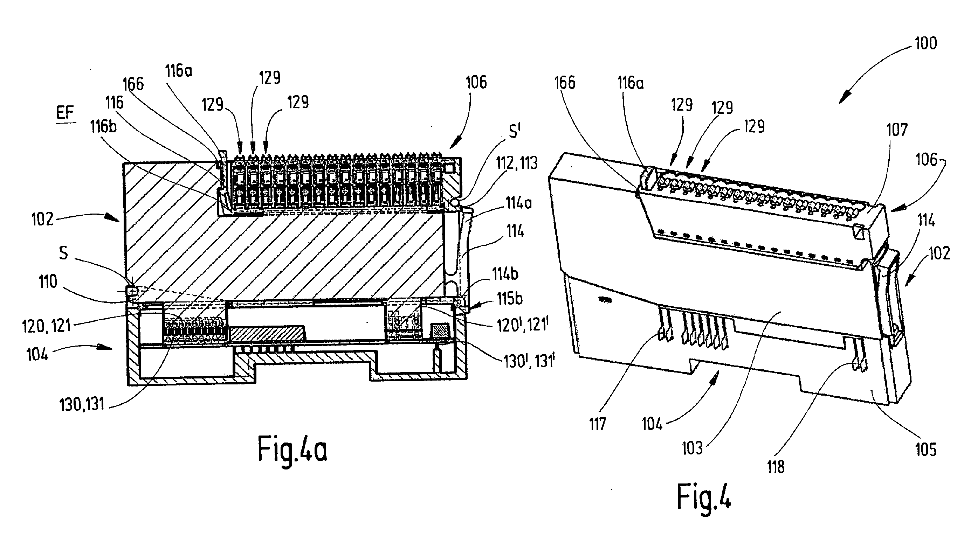

Fig. 4 zeigt eine perspektivische Darstellung eines ersten Ausführungsbeispiels eines Moduls 100, das ein erstes Modulteil 102, ein zweites Modulteil 104, und ein drittes Modulteil 106 umfasst. Fig. 4a zeigt eine entsprechende Querschnittsansicht des in Fig. 4 gezeigten Moduls 100. Das erste bzw. zweite Modulteil 102, 104 in diesem Ausführungsbeispiel kann insbesondere ein erstes bzw. zweites Modulteil sein, wie in Bezug auf Fig. 2 und Fig. 3 erläutert. Das dritte Modulteil 106 umfasst ein Gehäuse 107. Das dritte Modulteil 106 umfasst weiterhin zumindest einen externen Anschluss 129 zum Anlegen eines Signals oder einer Spannung von außen. Die Anschlüsse 129 können insbesondere die in Bezug auf Fig. 1 beschriebenen Anschlüsse 29 sein oder umfassen. In Fig. 4 und Fig. 4a sind eine Mehrzahl von externen Anschlüssen 129 dargestellt, die nebeneinanderliegend am Gehäuse 107 des dritten Modulteils angeordnet sind. Das dritte Modulteil 106 wird daher im Folgenden auch Anschlussmodulteil genannt. In dem dargestellten Ausführungsbeispiel umfasst das dritte Modulteil 106 sechzehn externe Anschlüsse 129, die in einer einzigen Reihe angeordnet sind (16-polig und einreihig). Es sollte jedoch verstanden werden, dass jede andere geeignete Anzahl und Anordnung von externen Anschlüssen vorgesehen sein kann. Ein externer Anschluss kann ein Ausgang zum Übermitteln eines Ausgangssignals (beispielsweise an einen Aktor) oder ein Eingang zum Aufnehmen eines Eingangssignals (beispielsweise von einem Sensor) sein.

Wie bereits in Bezug auf Fig. 2 erläutert, können das erste Modulteil 102 und das zweite Modulteil 104 mechanisch und elektrisch in eine erste zusammengesetzte Anordnung zusammengesetzt werden. Auch das erste Modulteil 102 und das dritte Modulteil 106 können mechanisch und elektrisch in einer zweiten zusammengesetzten Anordnung zusammengesetzt werden. Fig. 4 und Fig. 4a zeigen die Modulteile in der ersten und zweiten zusammengesetzten Anordnung.

Das mechanische Zusammensetzen der Modulteile wird nun im Folgenden detaillierter beschrieben mit Bezug auf Fig. 4a. Wie in Fig. 4a ersichtlich, weist das dritte Modulteil (Anschlussmodulteil) 106 ein Schwenkhalterungselement 112 auf, an dem das erste Modulteil (Elektronikmodulteil) 104 lösbar gehalten werden kann bzw. wird. Das Schwenkhalterungselement 112 definiert so einen Schwenkpunkt S' mit einer Schwenkachse A'. Auf diese Weise können das erste Modulteil 102 und das dritte Modulteil 106 durch eine Schwenkbewegung entlang einer definierten Bewegungsbahn in die zweite zusammengesetzte Anordnung mechanisch zusammengesetzt werden. Wie in Fig. 4a ersichtlich, umfasst auch das erste Modulteil (Elektronikmodulteil) 102 ein Schwenkhalterungselement 110, an dem das zweite Modulteil 104 (Busmodulteil) lösbar gehalten werden kann bzw. wird. Das Schwenkhalterungselement 110 definiert so einen Schwenkpunkt S mit einer Schwenkachse A. Auf diese Weise können das erste Modulteil 102 und das zweite Modulteil 104 durch eine Schwenkbewegung entlang einer definierten Bewegungsbahn in die zweite zusammengesetzte Anordnung zusammengesetzt werden. In dem in Fig. 4a dargestellten Ausführungsbeispiel umfasst das Schwenkhalterungselement 110, 112 jeweils einen Vorsprung (z.B. gekrümmter Vorsprung, Haken oder ähnliches), der in eine Aussparung des entsprechend anderen Modulteils eingreift. Es wird so eine schwenkbare Verbindung bereitgestellt. Die Modulteile können so durch eine einfache Schwenkbewegung um einen fest definierten Schwenkpunkt sicher und zuverlässig zusammengesetzt werden. In dem dargestellten Ausführungsbeispiel sind das Schwenkhaltungselement 110 des ersten Modulteils 102 und das Schwenkhalterungselement 112 des dritten Modulteils an sich einander gegenüberliegenden Seiten des Moduls 100 angeordnet. Somit ist in das dritte Modulteil 106 in eine erste Richtung (nach rechts in Fig. 4a) abschwenkbar und das erste Modulteils 102 ist in eine zweite, der ersten entgegengesetzte Richtung (nach links in Fig. 4a) abschwenkbar.

Das elektrische Zusammensetzen der Modulteile wird nun im Folgenden detaillierter beschrieben mit Bezug auf Fig. 4a. Das erste Modulteil (Elektronikmodulteil) 102 umfasst zumindest einen elektrischen Kontakt 120 und das zweite Modulteil (Busmodulteil) 104 umfasst zumindest einen ersten elektrischen Gegenkontakt 130, der in der ersten zusammengesetzten Anordnung den ersten elektrischen Kontakt 120 kontaktiert zur elektrischen Verbindung zwischen dem ersten Modulteil (Elektronikmodulteil) 102 und dem zweiten Modulteil (Busmodulteil) 104. Der erste elektrische Kontakt 120 des ersten Modulteils 102 ist eine Leiterbahn auf einer nicht-leitenden Platte, so dass eine Leiterplatte 121 gebildet wird. Der erste Gegenkontakt 130 des zweiten Modulteils 104 ist ein Kontaktelement (Pin), das in einem Stecker oder Buchse 131 angeordnet ist. In den Stecker oder die Buchse 131 kann die Leiterplatte 121 eingeführt werden. Es wird somit eine Steckverbindung gebildet. Insbesondere sind eine Mehrzahl von elektrischen Kontakten 120 und eine Mehrzahl von entsprechenden Gegenkontakten 130 vorgesehen. Die Mehrzahl von Kontakten 120 sind nebeneinanderliegend auf der Leiterplatte 121 angeordnet. Die Mehrzahl von entsprechenden Gegenkontakten 130 sind entsprechend nebeneinanderliegend in dem Stecker oder Buchse 131 angeordnet.

Wie in Fig. 4 und Fig. 4a zu sehen, bilden die Kontakte 120 und die entsprechenden Gegenkontakte 130 jeweils eine erste Gruppe. In diesem Ausführungsbeispiel dient die erste Gruppe dazu, die Spannung oder das Signal des Kommunikationsbuses, der mittels der Busanschlüsse 117 durchgeschaltet wird, von dem zweiten Modulteil (Busmodulteil) 104 auf das erste Modulteil (Elektronikmodulteil) 102 zu übertragen. Es ist weiterhin eine zweite Gruppe von Kontakten 120' auf einer entsprechenden Leiterplatte 121' vorgesehen, sowie entsprechende Gegenkontakte 130' in einem Stecker oder Buchse 131', wie bereits in Bezug auf die Kontakte 120 und Gegenkontakte 130 beschrieben. In diesem Ausführungsbeispiel dient die zweite Gruppe der Kontakte 120' bzw. Gegenkontakte 130' dazu, die Spannung des Versorgungsspannungsbuses, der mittels der Busanschlüsse 118 durchgeschaltet wird, von dem zweiten Modulteil (Busmodulteil) 104 auf das erste Modulteil (Elektronikmodulteil) 102 zu übertragen.

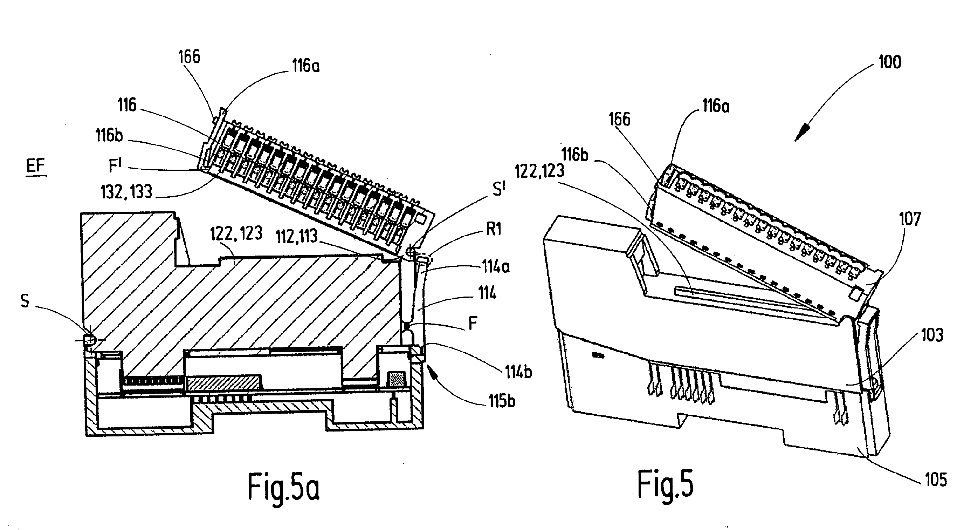

Fig. 5 zeigt eine perspektivische Darstellung des ersten Ausführungsbeispiels des Moduls 100 der Fig. 4 in einem Zustand, in dem das dritte Modulteil (Anschlussmodulteil) 106 gelöst wird. Fig. 5a zeigt eine entsprechende Querschnittsansicht des in Fig. 5 gezeigten Moduls 100. Wie in Fig. 5 und Fig. 5a zu sehen umfasst auch das dritte Modulteil (Anschlussmodulteil) 106 zumindest einen ersten elektrischen Kontakt 132 und das erste Modulteil (Elektronikmodulteil) 102 umfasst zumindest einen entsprechenden ersten elektrischen Gegenkontakt 122, der in der zweiten zusammengesetzten Anordnung den ersten elektrischen Kontakt 132 des dritten Modulteils (Busmodulteils) 106 kontaktiert zur elektrischen Verbindung zwischen dem ersten Modulteil (Elektronikmodulteil) 102 und dem dritten Modulteil (Anschlussmodulteil) 106. Der erste elektrische Gegenkontakt 122 des ersten Modulteils 102 ist eine Leiterbahn auf einer nicht-leitenden Platte, so dass eine Leiterplatte 123 gebildet wird. Der erste elektrische Kontakt 132 des dritten Modulteils 106 ist ein Kontaktelement (Pin), das in einem Stecker oder Buchse 133 angeordnet ist. In den Stecker oder die Buchse 133 kann die Leiterplatte 123 eingeführt werden. Es wird somit eine Steckverbindung gebildet. Insbesondere sind eine Mehrzahl von ersten elektrischen Kontakten 132 des dritten Modulteils 106 und eine Mehrzahl von entsprechenden ersten elektrischen Gegenkontakten 122 des ersten Modulteils 102 vorgesehen. Die Mehrzahl von ersten elektrischen Kontakten 132 des dritten Modulteils 106 sind nebeneinanderliegend in dem Stecker oder Buchse 133 angeordnet. Die Mehrzahl von entsprechenden ersten elektrischen Gegenkontakten 122 des ersten Modulteils 102 sind entsprechend nebeneinanderliegend auf der Leiterplatte 123 angeordnet.

Um das erste und zweite Modulteil 102, 104 in der ersten zusammengesetzten Anordnung aneinander zu sichern, umfasst das erste Modulteil 102 (Elektronikmodulteil) ein Sicherungselement 114 mit einem Sicherungseingriffsabschnitt 114b. Das Sicherungselement 114 bzw. der Sicherungseingriffsabschnitt 114b ist in eine erste und eine zweite Position beweglich. In der ersten Position, wie in Fig. 4 und Fig. 4a dargestellt, ist der Sicherungseingriffsabschnitt 114b mit dem zweiten Modulteil 104 (Busmodulteil) in der ersten zusammengesetzten Anordnung im sichernden Eingriff, so dass das erste Modulteil (Elektronikmodulteil) 102 und das zweite Modulteil (Busmodulteil) 104 aneinander gesichert sind. Der Sicherungseingriffsabschnitt 114b der Fig. 4a ist ein Vorsprung oder Balken, der in der ersten Position in sicherndem Eingriff mit einer Aussparung 115b des zweiten Modulteils 104 ist. Es sollte verstanden werden, dass dieses mechanische Eingreifen auf jede geeignete Art erreicht bzw. beschrieben werden kann. Beispielsweise kann auch ein Vorsprung oder Balken des zweiten Modulteils 104 in eine Aussparung des ersten Modulteils 102 bzw. des Sicherungselementes 114 eingreifen.

In der zweiten Position (in Fig. 4 und Fig. 5 nicht dargestellt) des Sicherungselementes 114 ist der Sicherungseingriffsabschnitt 114b in der ersten zusammengesetzten Anordnung derart angeordnet, dass das erste Modulteil (Elektronikmodulteil) 102 und das zweite Modulteil (Busmodulteil) 104 voneinander lösbar sind. In der zweiten Position des Sicherungselementes 114 sind das erste Modulteil (Elektronikmodulteil) 102 und das zweite Modulteil (Busmodulteil) 104 daher nicht aneinander gesichert. Das Sicherungselement 114 umfasst weiterhin einen Sicherungsbetätigungsabschnitt 114a, mittels dessen das Sicherungselement 114 in der ersten zusammengesetzten Anordnung zwischen der ersten und zweiten Position beweglich ist bei Ausüben einer Kraft auf den Sicherungsbetätigungsabschnitt 114a.

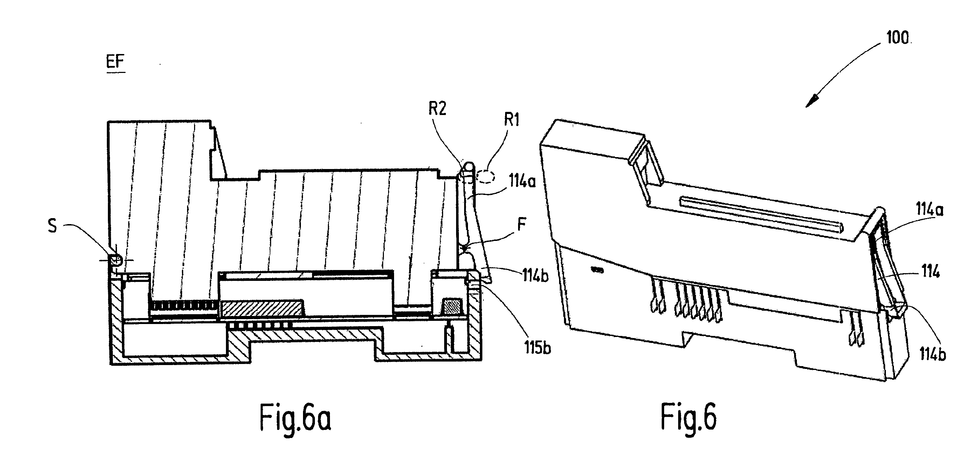

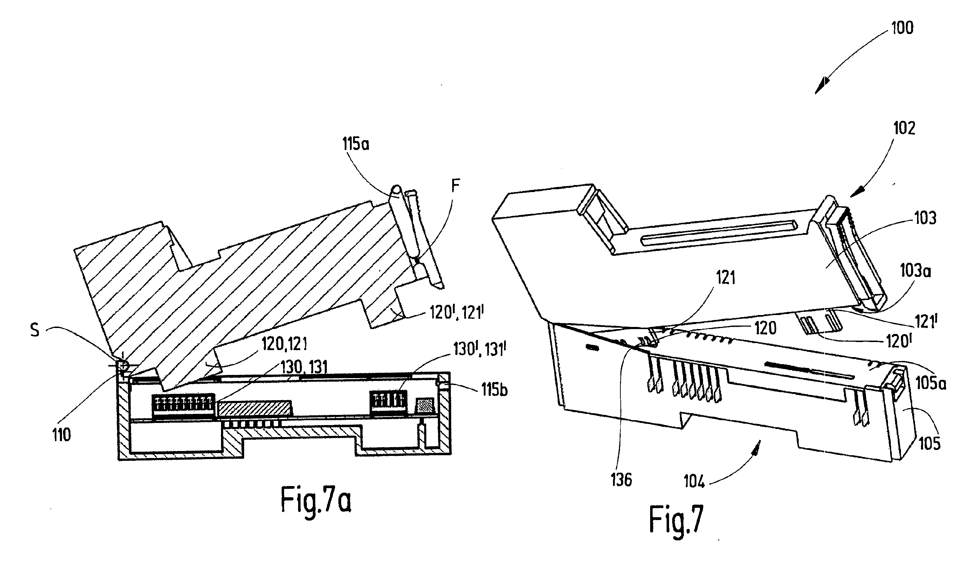

Fig. 6 zeigt eine perspektivische Darstellung des ersten Ausführungsbeispiels des Moduls 100 der Fig. 4 und der Fig. 5 in einem Zustand, in dem das erste Modulteil 102 in der ersten zusammengesetzten Anordnung lösbar ist. Fig. 6a zeigt eine entsprechende Querschnittsansicht des in Fig. 6 gezeigten Moduls 100. Fig. 7 zeige eine perspektivische Darstellung des ersten Ausführungsbeispiels des Moduls 100 der Fig. 4 bis 6 in einem Zustand, in dem das erste Modulteil 102 gelöst wird. Fig. 7a zeigt eine entsprechende Querschnittsansicht des in Fig. 7 gezeigten Moduls.

In Fig. 5 und Fig. 5a ist das Sicherungselement 114 in der ersten Position dargestellt, in der das erste Modulteil (Elektronikmodul) 102 und das zweite Modulteil (Busmodulteil) 104 aneinander gesichert sind. Der Sicherungsbetätigungsabschnitt 114a ist hier in der ersten Position in einem ersten Raumbereich R1 angeordnet. In Fig. 6 und Fig. 6a ist das Sicherungselement 114 in der zweiten Position dargestellt, in der das erste Modulteil (Elektronikmodulteil) 102 und das zweite Modulteil (Busmodulteil) 104 voneinander lösbar sind. Der Sicherungsbetätigungsabschnitt 114a ist hier in der zweiten Position in einem zweiten Raumbereich R2 angeordnet.

Das dritte Modulteil 106 weist einen Blockierabschnitt 113 auf, der in der zweiten zusammengesetzten Anordnung bzw. Zustand (Fig. 4 und Fig. 4a) zumindest teilweise in dem zweiten Raumbereich R2 angeordnet ist. In dem dargestellten Ausführungsbeispiel ist der Blockierabschnitt 113 ein Vorsprung, bzw. umfasst einen Vorsprung, der den Sicherungsbetätigungsabschnitt 114a kontaktiert. Es wird also ein Blockierabschnitt 113 verwendet, der derart ausgebildet ist, dass das Sicherungselement 114 in der ersten und zweiten zusammengesetzten Anordnung daran gehindert bzw. blockiert wird, sich in die zweite Position zu bewegen, in der das erste Modulteil (Elektronikmodulteil) 102 und das zweite Modulteil (Busmodulteil) 104 voneinander lösbar wären. Das erste Modulteil (Elektronikmodulteil) 102 wird dadurch blockiert, bis das dritte Modulteil (Anschlussmodulteil) 106 demontiert ist. Das Abnehmen oder Lösen des ersten Modulteils (Elektronikmodulteil) 102 von dem zweiten Modulteil (Busmodulteil) 104 ist also nur möglich, wenn das dritte Modulteil (Anschlussmodulteil) 106 demontiert ist. Das erste Modulteil (Elektronikmodulteil) 102 kann daher nicht von dem zweiten Modulteil (Busmodulteil) 104 abgezogen werden, wenn das Modul noch im Einsatz ist, beispielsweise wenn Spannungen oder Signale an den externen Anschlüssen 129 des Anschlussmodulteils 106 anliegen. Es kann daher nicht zu Fehlern auf dem Bus und/oder an angeschlossenem Peripheriegerät (z.B. Aktor) kommen. Des Weiteren kann ein Benutzer nicht durch hohe Spannungen verletzt werden. In dem dargestellten Ausführungsbeispiel ist der Blockierabschnitt 113 ein Teil des Schwenkhalterngselementes 112 bzw. fällt mit diesem zusammen.

In dem dargestellten Ausführungsbeispiel der Fig. 4 bis 7 ist das Sicherungselement 114 ein Hebel mit einem definierten Fixpunkt F. Der Hebel ist hier ein zweiseitiger Hebel mit einem ersten und einem zweiten Hebelteil bezüglich des Fixpunktes F. Der Sicherungsbetätigungsabschnitt 114 befindet sich auf dem ersten Hebelteil und der Sicherungseingriffsabschnitt 114b befindet sich auf dem zweiten Hebelteil. Durch Ausüben einer Kraft auf den Sicherungsbetätigungsabschnitt 114 des Hebels ist das Sicherungselement 114 bzw. der Hebel zwischen der ersten Position (Fig. 4 und Fig. 4a, Fig. 5 und Fig. 5a) und der zweiten Position beweglich (Fig. 6 und Fig. 6a). Das Sicherungselement 114 ist an dem Gehäuse 103 des ersten Modulteils 102 befestigt bzw. integral damit ausgeformt. Durch die Befestigung des Sicherungselements 114 (bzw. des Hebels) an dem Gehäuse 103 wird der Fixpunkt F definiert.

Es wird eine Ebene EF definiert, die senkrecht zu einer durch den Fixpunkt F des Hebels definierten Fixpunktachse FA angeordnet ist. In den Fig. 4 bis 6 verläuft die Fixpunktachse FA senkrecht zur Zeichenebene und die Ebene EF liegt in oder parallel zu der Zeichenebene. Der Sicherungsbetätigungsabschnitt 114a des Hebels ist in einer Richtung in der Ebene EF beweglich. Mit anderen Worten kann der Sicherungsbetätigungsabschnitt 114a des Hebels in Richtung der Zeichenebene hinund herbewegt werden. In der ersten Position (Fig. 4 und Fig. 4a, Fig. 5 und Fig. 5a) ist der Sicherungsbetätigungsabschnitt 114a in einer ersten Winkellage in der Ebene EF angeordnet. Der Sicherungsbetätigungsabschnitt 114a ist dann in dem ersten Raumbereich R1 angeordnet. In der zweiten Position (Fig. 6 und Fig. 6a) ist der Sicherungsbetätigungsabschnitt 114a des Hebels in einer anderen, zweiten Winkellage in der Ebene EF angeordnet. Der Sicherungsbetätigungsabschnitt 114a ist dann im zweiten Raumbereich R2 angeordnet. Wie in Fig. 4a zu sehen, ist der Blockierabschnitt 113 in der zweiten zusammengesetzten Anordnung bzw. Zustand zumindest teilweise in einem Bereich zwischen der ersten Winkellage und der zweiten Winkellage angeordnet. Der Vorsprung bzw. Blockierabschnitt 113 erstreckt sich hier bis in den Bereich zwischen der ersten Winkellage und der zweiten Winkellage.

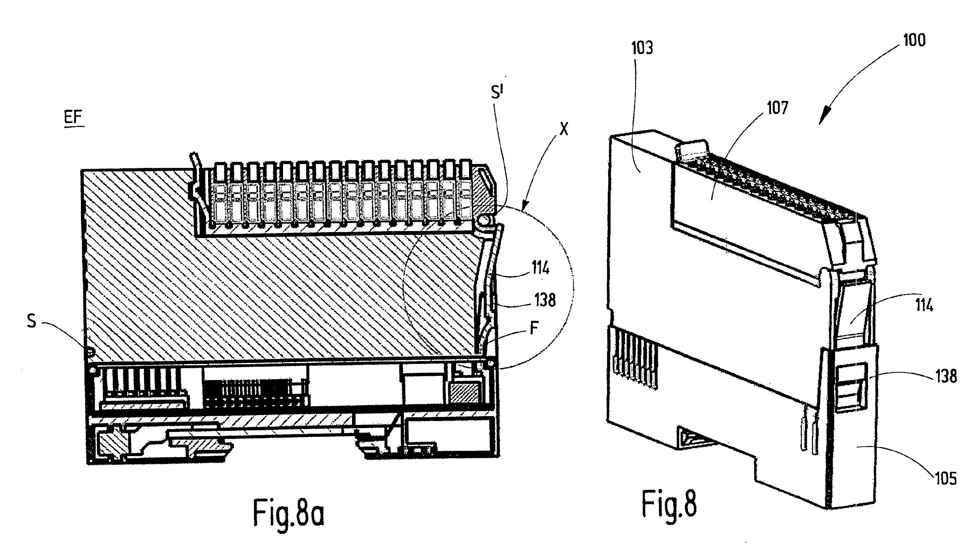

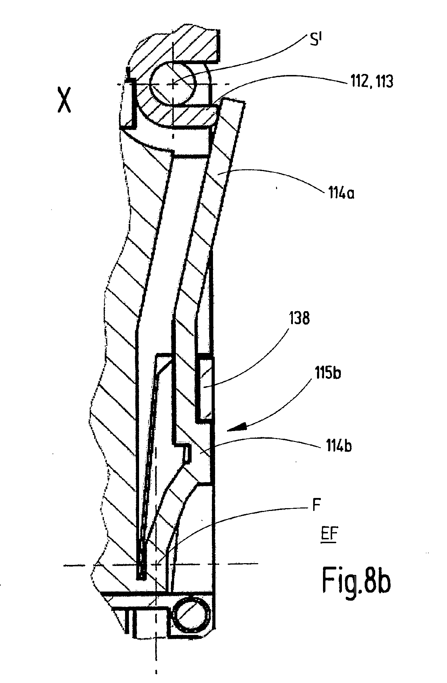

Fig. 8 zeigt eine perspektivische Darstellung eines zweiten Ausführungsbeispiels eines Moduls 100 mit einem ersten Modulteil 102, einem zweiten Modulteil 104 und einem dritten Modulteil 106 in einer ersten und zweiten zusammengesetzten Anordnung. Fig. 8a zeigt eine entsprechende Querschnittsansicht des in Fig. 8 gezeigten Moduls 100. Es wird im Wesentlichen auf die Ausführungen zu dem ersten Ausführungsbeispiel in Bezug auf Fig. 4 bis 7 verwiesen. Der Unterschied des in Fig. 8 und Fig. 8a dargestellten zweiten Ausführungsbeispiels verglichen mit dem ersten Ausführungsbeispiel der Fig. 4 bis 7 besteht jedoch darin, dass das Sicherungselement 114 hier ein einseitiger Hebel ist. Fig. 8b zeigt einen vergrößerten Bereich X der Querschnittsansicht der Fig. 8a. Das Sicherungselement 114 in Form eines einseitigen Hebels ist hier vergrößert dargestellt. Der Sicherungsbetätigungsabschnitt 114a und der Sicherungseingriffsabschnitt 114b sind beide auf dem einseitigen Hebel angeordnet. Der Sicherungseingriffsabschnitt 114b ist ein Vorsprung oder Balken, der in der ersten Position (wie in Fig. 8, Fig. 8a und Fig. 8b dargestellt) in sicherndem Eingriff mit einer Aussparung 115b des zweiten Modulteils 104 ist. Die Aussparung 115b des zweiten Modulteils 104 befindet sich in einem (in Bezug auf die Grenzfläche oder Backplane) hervorstehenden Abschnitt 138 des Gehäuses 105 des zweiten Modulteils 104.

Wie in Fig. 4, 4a, 5 und 5a zu sehen, umfasst auch das dritte Modulteil 106 (Anschlussmodulteil) ein Sicherungselement 116 mit einem Sicherungseingriffsabschnitt 116b, um das erste und dritte Modulteil 102, 106 in der zweiten zusammengesetzten Anordnung aneinander zu sichern. Das Sicherungselement 116 bzw. der Sicherungseingriffsabschnitt 116b ist in eine erste und eine zweite Position beweglich. In der ersten Position, wie in Fig. 4a dargestellt, ist der Sicherungseingriffsabschnitt 116b mit dem ersten Modulteil 102 (Elektronikmodulteil) in der zweiten zusammengesetzten Anordnung im sichernden Eingriff, so dass das erste Modulteil (Elektronikmodulteil) 102 und das dritte Modulteil (Anschlussmodulteil) 106 aneinander gesichert sind. Der Sicherungseingriffsabschnitt 116b der Fig. 4a ist ein Vorsprung oder Balken, der in der ersten Position in sicherndem Eingriff mit einer Aussparung des ersten Modulteil 102 ist. Es sollte verstanden werden, dass dieses mechanische Eingreifen auf jede geeignete Art erreicht bzw. beschrieben werden kann. Beispielsweise kann auch ein Vorsprung oder Balken des ersten Modulteils 102 in eine Aussparung des dritten Modulteils 106 bzw. des Sicherungselementes 116 eingreifen.

In der zweiten Position (in Fig. 4 und Fig. 5 nicht dargestellt) des Sicherungselementes 116 ist der Sicherungseingriffsabschnitt 116b in der zweiten zusammengesetzten Anordnung derart angeordnet, dass das erste Modulteil (Elektronikmodulteil) 102 und das dritte Modulteil (Anschlussmodulteil) 106 voneinander lösbar sind. In der zweiten Position des Sicherungselementes 116 sind das erste Modulteil (Elektronikmodulteil) 102 und das dritte Modulteil (Anschlussmodulteil) 106 daher nicht aneinander gesichert. Das Sicherungselement 116 umfasst weiterhin einen Sicherungsbetätigungsabschnitt 116a, mittels dessen das Sicherungselement 116 in der zweiten zusammengesetzten Anordnung zwischen der ersten und zweiten Position beweglich ist bei Ausüben einer Kraft auf den Sicherungsbetätigungsabschnitt 116a. In dem dargestellten Ausführungsbeispiel ist das Sicherungselement 116 ein (einseitiger) Hebel mit einem definierten Fixpunkt F'. Das Sicherungselement 116 ist an dem Gehäuse 107 des dritten Modulteils 106 befestigt bzw. integral damit ausgeformt. Durch die Befestigung des Sicherungselements 116 (bzw. des Hebels) an dem Gehäuse 107 wird der Fixpunkt F' definiert.

Des Weiteren umfasst das dritte Modulteil 106 einen Überdehnschutz (bzw. Abrissschutz) 166, um das Sicherungselement 116 gegen ein Überdehnen zu schützen (bzw. gegen en Abreißen von dem dritten Modulteil 106). Das Sicherungselement 116 (oder Hebel) ist somit sowohl während des Transportes als auch beim Aufbau (Zusammensetzen des Moduls) gegen ein Überdehnen bzw. Abreißen geschützt. Wie in Fig. 4, 4a, 5, und 5a zu sehen, ist der Überdehnschutz (bzw. Abrissschutz) 166 in diesem Ausführungsbeispiel ein Balken, der vor dem Sicherungselement 116 des dritten Modulteils 106 angeordnet ist. Durch den Balken 166 wird eine Aussparung gebildet, in der der Sicherungsbestätigungsabschnitt 116b angeordnet ist. Die Aussparung ist groß genug, um den Sicherungsbetätigungsabschnitt 116b zwischen der ersten und der zweiten Position zu bewegen.

Das mechanische Zusammensetzen bzw. Lösen des ersten Modulteils (Elektronikmodulteil) 102 und des zweiten Modulteils (Busmodulteil) 104 wird im Folgenden detaillierter beschrieben. Das Gehäuse 103 des ersten Modulteils (Elektronikmodulteil) 102 umfasst hier eine Grenzfläche 103a und das Gehäuse 105 des zweiten Modulteils (Busmodulteil) 104 umfasst eine Grenzfläche 105a (in Fig. 7 und 7a sichtbar), die sich in der ersten zusammengesetzten Anordnung bzw. Zustand (wie beispielsweise in Fig. 4 bis 6 zu sehen), derart gegenüberliegen, dass eine Grenzebene G definiert ist. In den Fig. 4a, 5a, 6a und 7a verläuft die Grenzebene G horizontal in die Zeichenebene hinein. Die Grenzflächen 105a der zweiten Modulteile (Busmodulteile) 104 bilden die Backplane. Die Leiterplatten 121, 121' des ersten Modulteils 102 können in entsprechende Aussparungen (mit Gegenkontakten 130, 130' bzw. Steckern oder Buchsen 131, 131') in dem Gehäuse 105 bzw. der Grenzfläche 105a des zweiten Modulteils eingeführt werden. Das erste Modulteil (Elektronikmodulteil) 102 und zweite Modulteil (Busmodulteil) 104 liegen in der ersten zusammengesetzten Anordnung bzw. Zustand daher plan aufeinander auf, in der Grenzebene G.

In Fig. 7 und 7a werden das erste Modulteil (Elektronikmodulteil) 102 und das zweite Modulteil (Busmodulteil) 104 durch eine Schwenkbewegung entlang einer definierten Bewegungsbahn um einen Schwenkpunkt S herum voneinander gelöst. Das Schwenkhalterungselement 110, das den Schwenkpunkt S mit der Schwenkachse A definiert, wurde bereits im Zusammenhang mit dem mechanischen Zusammensetzen der Modulteile erläutert. Wie in Fig. 7 zu sehen, umfasst das Gehäuse 105 des zweiten Modulteils (Busmodulteil) 104 eine schräge Kante 136, die vom Schwenkpunkt S aus schräg verläuft. Es ist jeweils eine schräge Kante 136 auf beiden Seiten des Gehäuses 105 vorgesehen. In dem Raum zwischen den beiden schrägen Kanten 136 wird eine Führungstasche gebildet, in der das erste Modulteil (Elektronikmodulteil) 102 beim Schwenken geführt werden kann. Es werden so die Freiheitsgrade beim Schwenken minimiert, bzw. das Spiel im Schwenkpunkt wird minimiert. Die Modulteile können so sicher und zuverlässig zusammengesetzt werden. Insbesondere kann so die Leiterplatte 120, 120' des ersten Modulteils (Elektronikmodulteil) 102 genau bzw. sauber in den entsprechenden Stecker oder Buchse 130, 130' des zweiten Modulteils (Busmodulteil) 104 eingeführt werden.

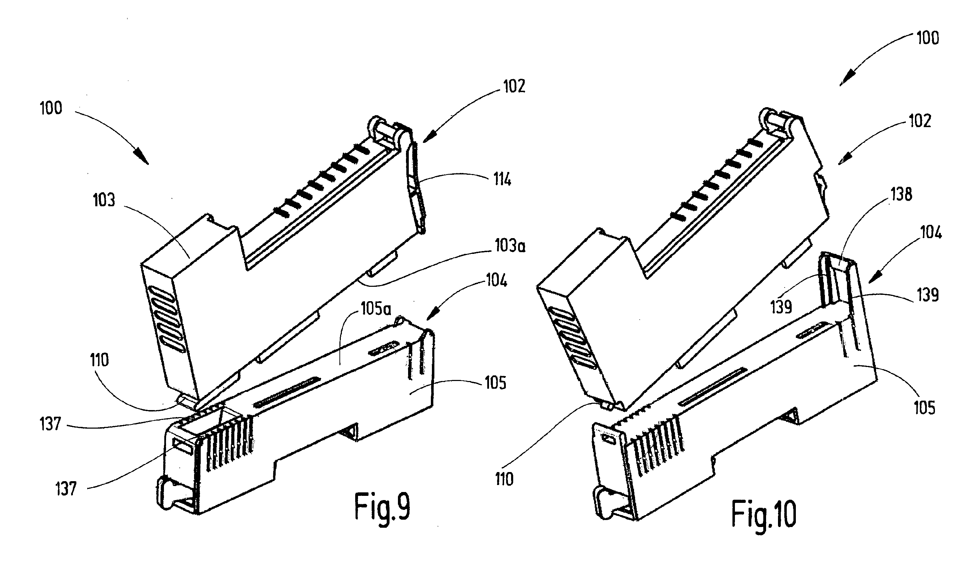

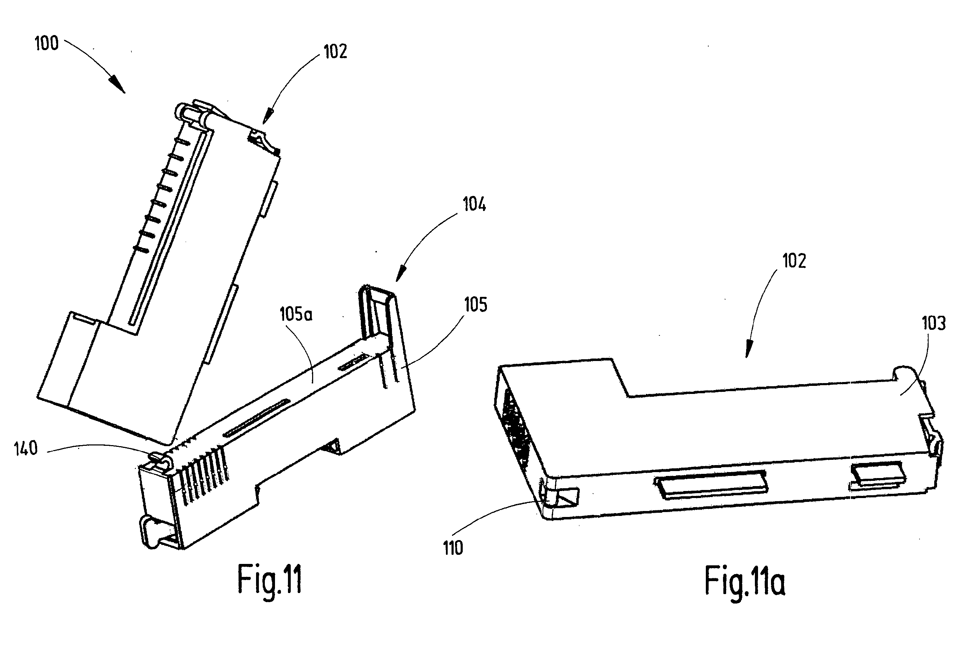

Fig. 9 bis 11 zeigen jeweils ein weiteres Ausführungsbeispiel eines Moduls 100 an einem ersten Modulteil 102 und einem zweiten Modulteil 104. Es wird im Wesentlichen auf die Ausführungen zu dem ersten und zweiten Ausführungsbeispiel in Bezug auf Fig. 4 bis 8 verwiesen. Der Unterschied des in Fig. 9 dargestellten Ausführungsbeispiels verglichen mit dem ersten Ausführungsbeispiel der Fig. 4 bis 7 besteht jedoch darin, dass die Führungstasche, in die das Schwenkhalterungselement 110 eingeführt wird, zwischen zwei geraden Kanten 137 ausgebildet ist. Die geraden Kanten liegen in der Grenzebene G bzw. in der Grenzfläche 105a. Das Schwenkhalterungselement des ersten Modulteils 102 erstreckt sich hier über die Grenzebene G bzw. die Grenzfläche 103a des ersten Modulteils 103a hinaus in Form eines Vorsprungs oder Balkens. Ein weiterer Unterschied des Ausführungsbeispiels der Fig. 9 besteht darin, dass das Sicherungselement 114 mit einer ebenen Oberfläche ausgebildet ist. Das in Fig. 10 dargestellte Ausführungsbeispiel entspricht im Wesentlichen dem in Fig. 8 gezeigten Ausführungsbeispiel. Der Unterschied des in Fig. 10 gezeigten Ausführungsbeispiels mit dem ersten Ausführungsbeispiel der Fig. 4 bis 7 besteht darin, dass das Schwenkhalterungselement 110 in Form eines Vorsprungs nicht in einer Führungstasche geführt wird. Um dennoch eine saubere Schwenkbewegung zu gewährleisten, sind hier Führungen 139 an beiden Seiten des (in Bezug auf die Grenzfläche G oder Backplane) hervorstehenden Abschnitts 138 des Gehäuses 105 vorgesehen. Der Unterschied des in Fig. 11 dargestellten Ausführungsbeispiels verglichen mit dem ersten Ausführungsbeispiel der Fig. 4 bis 7 besteht darin, dass das Schwenkhalterungselement 110 des ersten Modulteils (Elektronikmodulteil) 102 einen Balken umfasst, der in einer durch das Gehäuse 103 des zweiten Modulteils gebildeten Aussparung angeordnet ist. Genauer gesagt wird diese Aussparung durch einen auf der Grenzfläche 105a angeordneten gekrümmten Vorsprung 140 gebildet. Das Schwenkhalterungselement 110 wird hier in dem Ausführungsbeispiel der Fig. 11 nicht durch einen hervorstehenden Vorsprung gebildet wie in dem ersten Ausführungsbeispiel mit Bezug auf Fig. 4 bis 7, sondern durch einen in einer Aussparung gebildeten Balken. Dementsprechend wird in Fig. 11 die Aussparung des zweiten Modulteils (Busmodulteil) 104, in die der Balken 110 eingreift, durch den gekrümmten Vorsprung 140 gebildet.

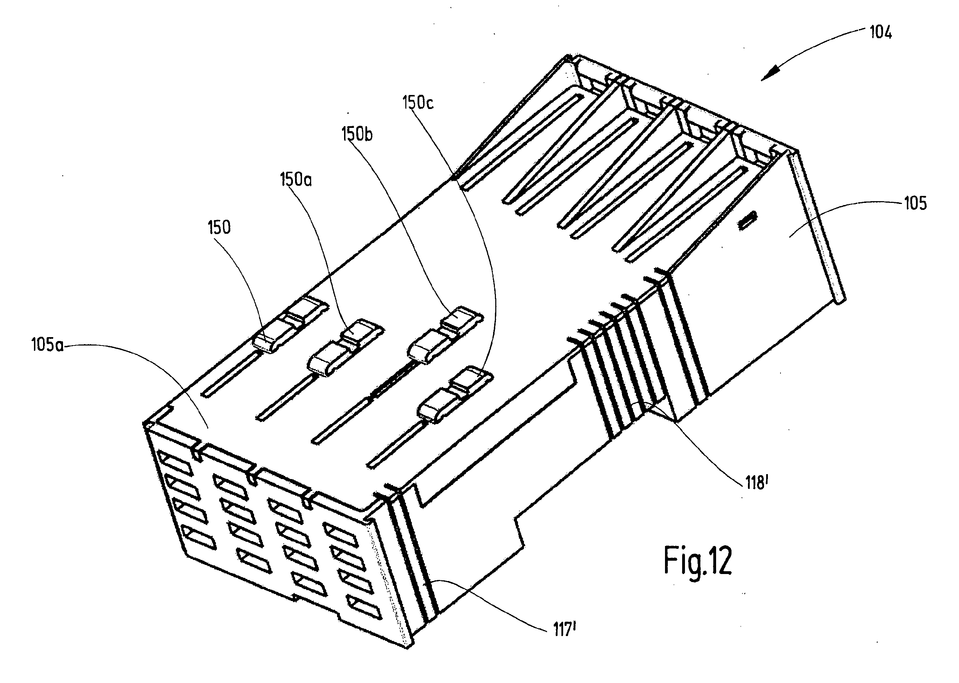

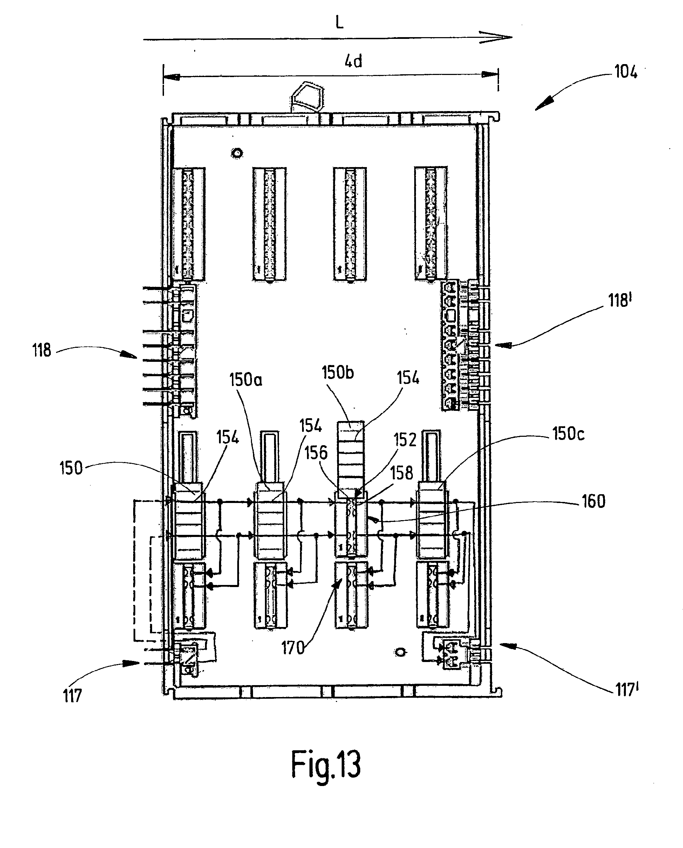

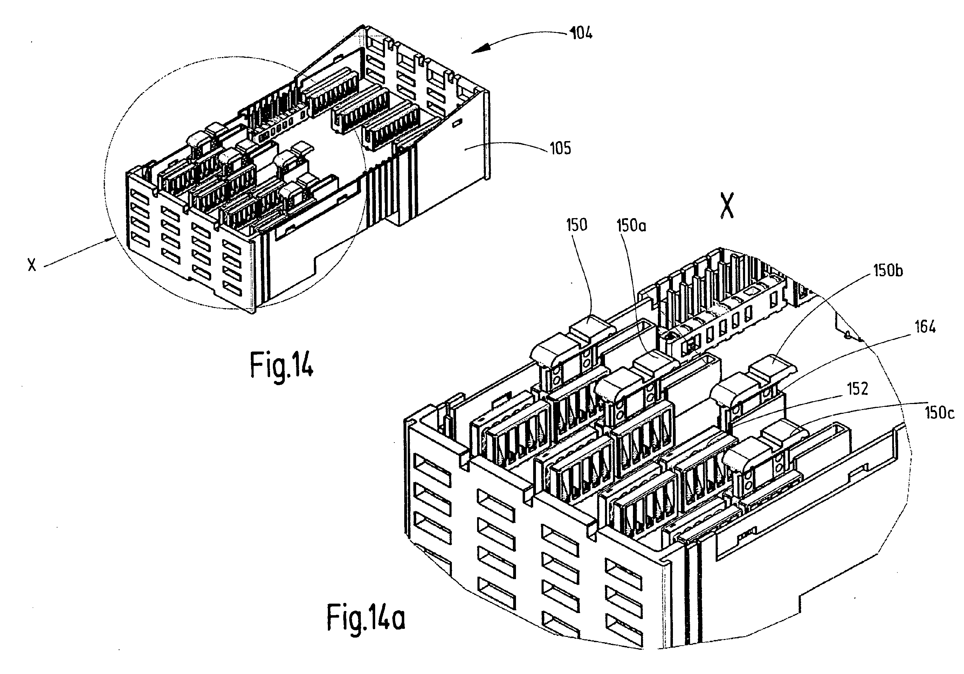

Fig. 12 zeigt eine perspektivische Darstellung eines Ausführungsbeispiels des zweiten Modulteils 104, insbesondere des zweiten Modulteils (Busmodulteil) 104 der Fig. 2 und 3. Fig. 13 zeigt eine Draufsicht von oben auf das zweite Modulteil 104 der Fig. 12. Fig. 14 zeigt eine perspektivische Innenansicht des zweiten Modulteils 104 der Fig. 12 und 13. Fig. 14a zeigt einen vergrößerten Bereich X der perspektivischen Ansicht der Fig. 14.

Das zweite Modulteil (Busmodulteil) 104 umfasst zumindest ein bewegliches Teil 150, welches in eine erste Position und eine zweite Position beweglich ist. In der ersten Position stellt das bewegliche Teil 150 eine elektrische Verbindung zwischen dem ersten Busanschluss 117 und dem zweiten Busanschluss 117' bereit. In der zweiten Position stellt das bewegliche Teil 150 eine Isolierstelle 152 zwischen dem ersten Busanschluss 117 und dem zweiten Busanschluss 117' bereit. Wie bereits in Bezug auf die vorhergehenden Figuren erläutert ist der erste und der zweite Busanschluss 117, 117' hier jeweils ein Busanschluss eines Versorgungsspannungsbusses, der eine Versorgungsspannung durchschaltet.

In dem in Fig. 12 bis 14 gezeigten Ausführungsbeispiel umfasst das zweite Modulteil (Busmodulteil) 104 eine der ganzen Zahl n entsprechende Anzahl von beweglichen Teilen 150, 150a-c. Da die Breite des zweiten Modulteils (Busmodulteil) 104 in diesem Ausführungsbeispiel das Vierfache der Grundbreite d ist, wie bereits in Bezug auf Fig. 2 und Fig. 3 erläutert, umfasst das zweite Modulteil 104 daher vier bewegliche Teile 150, 150a-c. Die beweglichen Teile 150, 150a-c sind jeweils in die erste Position und die zweite Position beweglich. Es sollte jedoch verstanden werden, dass das zweite Modulteil 104 eine beliebige Anzahl von beweglichen Teilen 150 umfassen kann. Insbesondere kann das zweite Modulteil 104 nur ein bewegliches Teil 150 umfassen, beispielsweise ebenfalls in Fig. 2 und 3 dargestellt. Im Folgenden wird nun die Funktion eines beweglichen Teils detaillierter beschrieben.

In dem dargestellten Ausführungsbeispiel des zweiten Modulteils (Busmodulteil) 104 sind (in einer Richtung von rechts nach links gesehen) das erste bewegliche Teil 150, das zweite bewegliche Teil 150a und das vierte bewegliche Teil 150c in der ersten Position. Nur das dritte bewegliche Teil 150b ist hier in der zweiten Position. Wie in Fig. 13 zu sehen, weist das zweite Modulteil (Busmodulteil) 104 einen ersten Kontaktpunkt 156 auf, der mit dem ersten Busanschluss 117' elektrisch verbunden ist, und einen zweiten Kontaktpunkt 158, der mit dem zweiten Busanschluss 117' elektrisch verbunden ist. Die Isolierstelle 152 befindet sich zwischen dem ersten Kontaktpunkt 156 und dem zweiten Kontaktpunkt 158, wenn das bewegliche Teil 150 in der zweiten Position ist (bewegliches Teil 150b in Fig. 13). Die Isolierstelle 152 ist hier ein luftgefüllter Bereich.

Das bewegliche Teil 150, 150a-c umfasst jeweils eine elektrische Leitung 154, die derart angeordnet ist, dass durch die elektrische Leitung 154 eine elektrische Verbindung zwischen dem ersten Kontaktpunkt 156 und dem zweiten Kontaktpunkt 158 bzw. zwischen dem ersten Busanschluss 117 und dem zweiten Busanschluss 117' bereitgestellt wird, wenn das bewegliche Teil 150 in der ersten Position ist (bewegliches Teil 150, 150a, 150c in Fig. 13). Jedes der beweglichen Teile 150, 150a-c umfasst hier eine elektrische Leitung, die derart angeordnet ist, dass durch die elektrischen Leitungen 154 eine elektrische Verbindung zwischen dem ersten Busanschluss 117 und dem zweiten Busanschluss 117' bereitgestellt wird, wenn jedes der beweglichen Teile 150, 150a-c in der ersten Position ist. Dies ist in dem in Fig. 13 dargestellten Zustand nicht der Fall, da das bewegliche Teil 150b in der zweiten Position ist, d.h. nicht jedes bewegliche Teil ist in der ersten Position. Jedes der beweglichen Teile 150, 150a-c kann also in seiner zweiten Position eine Isolierstelle 152 zwischen dem ersten Busanschluss 117 und dem zweiten Busanschluss 117' bereitstellen. In dem in Fig. 13 dargestellten Zustand ist dies nur das bewegliche Teil 150b. Durch diese Isolierstelle 152 wird der Versorgungsspannungsbus auf getrennt.

Wie in Fig. 14a zu sehen, ist das bewegliche Teil 150, 150a-c ein auf einer Führung 164 geführtes Schiebeelement, das zwischen der ersten und der zweiten Position verschiebbar ist. Das Schiebeelement umfasst einen unteren Bereich (in Bezug auf die Grenzfläche 105a oder Backplane), auf dem die elektrischen Verbindungen angeordnet sind, und einen oberen Bereich (in Bezug auf die Grenzfläche 105a oder Backplane), der zum manuellen Bedienen ausgebildet ist. Wie in Fig. 12 zu sehen ist das bewegliche Teil bzw. Schiebeelement mit dem oberen Bereich auf bzw. über der Grenzebene G bzw. der Grenzfläche 105a des zweiten Modulteils 105 angeordnet, so dass es leicht von außen zugänglich ist. Wie in Fig. 14a zu sehen, ist das Schiebeelement in diesem Ausführungsbeispiel linear zwischen der ersten und zweiten Position verschiebbar, parallel zu (bzw. in) der Grenzfläche 105a oder Backplane. Es sollte verstanden werden, dass das bewegliche Teil oder das Schiebeelement auf jede andere geeignete Art und Weise zwischen der ersten und der zweiten Position beweglich sein kann. Beispielsweise kann das Schiebeelement winkelförmig um einen definierten Drehpunkt zwischen der ersten und zweiten Position verschiebbar bzw. drehbar sein. In einem anderen Beispiel kann das bewegliche Teil ein Jumper sein, der in der ersten Position in die Isolierstelle eingesetzt werden kann oder eingesetzt ist und in der zweiten Position von der Steuerungsvorrichtung abgenommen werden kann oder abgenommen ist. Unter einem Jumper ist hier ein separates, komplett abnehmbares Bauteil mit einer elektrischen Leitung zu verstehen.

Das erste Modulteil (Elektronikmodulteil) 102, wie beispielsweise in Bezug auf die vorhergehenden Figuren beschrieben, wird hier insbesondere in einer ersten Bauform und einer zweiten Bauform bereitgestellt. Die erste Bauform des ersten Modulteils (Elektronikmodulteil) 102 kann hier ein Ein-/Ausgabemodulteil sein (z.B. für Fail Safe (FS-) oder Standard (ST-Anwendung)). In der zweiten Bauform kann das erste Modulteil (Elektronikmodulteil) 102 ein Spannungsversorgungsmodulteil (bzw. Einspeisemodulteil) sein zur Einspeisung eines Module Supply, d.h. einer internen Versorgungsspannung, oder zur Einspeisung eines Periphery Supply, d.h. einer externen Spannungsversorgung, um eine neue Potentialgruppe zu bilden.

In der zweiten Bauform (Spannungsversorgungsmodulteil) ist mindestens ein erster Kontakt 120' (insbesondere Kontakte 120' der zweiten Gruppe, wie zuvor beschrieben) bzw. Leiterplatte 121' des ersten Modulteils 102 derart angeordnet, dass diese in die Isolierstelle 152 eingeführt werden kann. Einer der Kontaktpunkte 156, 158 ist der elektrische Gegenkontakt 130 des zweiten Modulteils (Busmodulteil) 104. Es wird so in der ersten zusammengesetzten Anordnung der erste elektrische Kontakt 120' des ersten Modulteils (Elektronikmodulteil oder Spannungsversorgungsmodulteil) den einen Kontaktpunkt 156, 158 des zweiten Modulteils (Busmodulteil) kontaktiert zur elektrischen Verbindung zwischen dem ersten Modulteil 102 und dem zweiten Modulteil 104, wenn das bewegliche Teil 150 in der zweiten Position ist. Es wird so ein Einspeiseanschluss 160 bereitgestellt. Der Einspeiseanschluss 160 dient zur Verbindung mit dem ersten Modulteil (Spannungsversorgungsmodulteil bzw. Einspeisemodulteil) 102. Das erste Modulteil (Elektronikmodulteil) 102 hat also in der zweiten Bauform (Spannungsversorgungsmodulteil) seinen ersten elektrischen Kontakt 120' derart angeordnet, dass in der ersten zusammengesetzten Anordnung der erste elektrische Kontakt 120 mit dem Einspeiseanschluss 160 eine elektrische Verbindung zwischen dem ersten Modulteil 102 und dem zweiten Modulteil 104 bereitgestellt wird. Auf diese Weise wird von dem ersten Modulteil (Elektronikmodulteil bzw. Spannungsversorgungsmodulteil) 102 auf das zweite Modulteil (Busmodulteil) eine Spannung eingespeist.

Das zweite Modulteil (Busmodulteil) 104 umfasst weiterhin einen weiteren Anschluss 170, der mit der elektrischen Verbindung zwischen dem ersten Busanschluss 117 und dem zweiten Busanschluss 117' verbunden ist. Das erste Modulteil (Elektronikmodulteil) 102 hat in der ersten Bauform (Ein-/Ausgabemodulteil) seinen ersten elektrischen Kontakt 120' bzw. die Leiterplatte 121' derart angeordnet, dass in der ersten zusammengesetzten Anordnung der erste elektrische Kontakt 120' zusammen mit dem weiteren Anschluss 170 eine elektrische Verbindung zwischen dem ersten Modulteil (Elektronikmodulteil bzw. Ein-/Ausgabemodulteil) und dem zweiten Modulteil (Busmodulteil) 104 bereitstellt.

Wie in Fig. 13 durch Pfeile dargestellt, wird in diesem Ausführungsbeispiel die Versorgungsspannung auf dem Versorgungsspannungsbus von dem ersten Busanschluss 117 in Richtung des zweiten Busanschlusses 117' durchgeschaltet, hier also von links nach rechts in Längsrichtung L. Daher ist der oben beschriebene Kontaktpunkt hier der rechte Kontaktpunkt 158. Der Kontaktpunkt 158 wird also von dem ersten elektrischen Kontakt 120' des ersten Modulteils 102 kontaktiert. Der erste elektrische Kontakt 120' des ersten Modulteils 102 ist gegenüber dem anderen Kontaktpunkt 156 des zweiten Modulteils 104 isoliert. Auf diese Weise kann eine neue Spannung nach rechts hin eingespeist werden.

Es wird durch das oben beschrieben Ausführungsbeispiel also erreicht, dass, wenn das bewegliche Teil 150, 150a-c in der ersten Position ist, eine an einem der Busanschlüsse 117 anliegende Spannung zwischen dem ersten Busanschluss 117 und dem zweiten Busanschluss 117' durchgeschaltet wird, und, wenn das bewegliche Teil 150, 150a-c in der zweiten Position ist, eine galvanische Trennung zwischen dem ersten Busanschluss 117 und dem zweiten Busanschluss 117' bereitgestellt wird.

Anstelle von zwei unterschiedlichen Bauformen des zweiten Modulteils (Busmodulteil) 104 (eine Bauart mit durchgeschaltetem Bus und eine Bauart mit aufgetrenntem Bus) wird hier also nur eine einzige Bauart des zweiten Modulteils (Busmodulteil) 104 benötigt. Die Herstellungskosten sind durch die Herstellung nur einer Bauform des zweiten Modulteils (Busmodulteil) 104 geringer. Zudem wird eine erhöhte Benutzerfreundlichkeit bereitgestellt, da jede Bauart des ersten Modulteils (Elektronikmodulteil) 102 auf das zweite Modulteil (Busmodulteil) 104 aufgesetzt werden kann.

Obwohl vorhergehend eine Steuerungsvorrichtung zum automatisierten Steuern einer technischen Anlage beschrieben worden ist, sollte verstanden werden, dass die Steuerungsvorrichtung auch zum Steuern einer anderen Anwendung verwendet werden kann. Des Weiteren kann die Steuerungsvorrichtung jede andere Vorrichtung sein, in der elektrische Kontakte eines ersten Modulteils und Gegenkontakte eines zweiten Modulteils (durch Schwenkbewegung) zusammengeführt werden.

## Patentansprüche

1. Steuerungsvorrichtung (1) zum automatisierten Steuern einer technischen Anlage (10), mit einer Anzahl von in einer Längsrichtung (L) nebeneinander angeordneten Modulen (100), wobei die Module (100) jeweils zumindest ein Modulteil (104) umfassen, wobei das Modulteil (104) ein zweites Modulteil ist, und wobei zumindest ein Modul (100) das zweite Modulteil (104) und weiterhin ein erstes Modulteil (102) und ein drittes Modulteil (106) umfasst, wobei das erste Modulteil (102) und das zweite Modulteil (104) mechanisch und elektrisch in eine erste zusammengesetzte Anordnung zusammen gesetzt werden können, wobei auch das erste Modulteil (102) und das dritte Modulteil (106) mechanisch und elektrisch in einer zweiten zusammengesetzten Anordnung zusammengesetzt werden können, wobei das dritte Modulteil (106) zumindest einen ersten elektrischen Kontakt (132) und das erste Modulteil (102) zumindest einen entsprechenden ersten elektrischen Gegenkontakt (122) umfasst, der in der zweiten zusammengesetzten Anordnung den ersten elektrischen Kontakt (132) des dritten Modulteils (106) kontaktiert zur elektrischen Verbindung zwischen dem ersten Modulteil (102) und dem dritten Modulteil (106), wobei das erste Modulteil (102) zumindest einen weiteren elektrischen Kontakt (120) umfasst, und wobei das zweite Modulteil (104) zumindest einen weiteren elektrischen Gegenkontakt (130) umfasst, der in der ersten zusammengesetzten Anordnung den weiteren elektrischen Kontakt (120) kontaktiert zur elektrische Verbindung zwischen dem ersten und dem zweiten Modulteil (102, 104), wobei das zweite Modulteil (104) ferner ein Gehäuse (105) mit mindestens einen ersten elektrischen Busanschluss (117) an einer ersten Seite des Gehäuses (105) umfasst zur elektrischen Verbindung mit einem in Längsrichtung (L) danebenliegenden ersten Nachbarmodulteil, und wobei das zweite Modulteil (104) weiterhin mindestens einen zweiten elektrischen Busanschluss (117') an einer zweiten, der ersten Seite gegenüberliegenden Seite des Gehäuses (105) umfasst zur elektrischen Verbindung mit einem in Längsrichtung (L) danebenliegenden zweiten Nachbarmodulteil, wobei der erste Busanschluss (117) und der zweite Busanschluss (117') jeweils ein Busanschluss eines Versorgungsspannungsbusses ist, der eine Versorgungsspannung durchschaltet, **gekennzeichnet dadurch, dass** das dritte Modulteil (106) weiterhin zumindest einen externen Anschluss (129) zum Anlegen einer Spannung von außen umfasst, wobei das zweite Modulteil (104) zumindest ein bewegliches Teil (150) umfasst, welches in eine erste Position und eine zweite Position beweglich ist, wobei das bewegliche Teil (150) in der ersten Position eine elektrische Verbindung zwischen dem ersten Busanschluss (117) und dem zweiten Busanschluss (117') bereitstellt und in der zweiten Position eine Isolierstelle (152) zwischen dem ersten Busanschluss (117) und dem zweiten Busanschluss (117') bereitstellt, wobei das zweite Modulteil (104) einen ersten Kontaktpunkt (156) aufweist, der mit dem ersten Busanschluss (117') elektrisch verbunden ist, und einen zweiten Kontaktpunkt (158) aufweist, der mit dem zweiten Busanschluss (117') elektrisch verbunden ist, wobei sich die Isolierstelle (152) zwischen dem ersten Kontaktpunkt (156) und dem zweiten Kontaktpunkt (158) befindet, wenn das bewegliche Teil (150) in der zweiten Position ist, wobei der weitere elektrische Gegenkontakt (130) einer der Kontaktpunkte (156, 158) ist, so dass in der ersten zusammengesetzten Anordnung der weitere elektrische Kontakt (120) den einen Kontaktpunkt (156, 158) des zweiten Modulteils (104) kontaktiert zur elektrischen Verbindung zwischen dem ersten und zweiten Modulteil (102, 104), wenn das bewegliche Teil (150) in der zweiten Position ist, um einen Einspeiseanschluss (160) bereitzustellen, wobei das erste Modulteil (102) seinen weiteren elektrischen Kontakt (120) derart angeordnet hat, dass in der ersten zusammengesetzten Anordnung der weiteren elektrische Kontakt (120) zusammen mit dem Einspeiseanschluss (160) eine elektrische Verbindung zwischen dem ersten und zweiten Modulteil (102, 104) bereitgestellt wird, um von dem ersten Modulteil (102) auf das zweite Modulteil (104) eine Spannung einzuspeisen.

2. Steuerungsvorrichtung nach Anspruch 1, wobei zumindest eines der ersten Modulteile (102) eine Grundbreite (d) in Längsrichtung (L) aufweist und wobei das zweite Modulteil (104) eine Breite in Längsrichtung (L) aufweist, die ein ganzzahliges (n) Vielfaches der Grundbreite (d) ist, insbesondere ein gradzahliges Vielfaches.

3. Steuerungsvorrichtung nach Anspruch 2, wobei das zweite Modulteil (104) eine der ganzen Zahl (n) entsprechende Anzahl von beweglichen Teilen (150, 150a-c) umfasst, die jeweils in die erste Position und die zweite Position beweglich sind, wobei jedes der beweglichen Teile (150, 150a-c) eine elektrische Leitung (154) umfasst, die derart angeordnet ist, dass durch die elektrischen Leitungen (154) eine elektrische Verbindung zwischen dem ersten Busanschluss (117) und dem zweiten Busanschluss (117') bereitgestellt wird, wenn jedes der beweglichen Teile (150, 150a-c) in der ersten Position ist, und wobei jedes der beweglichen Teile (150, 150a-c) in seiner zweiten Position eine Isolierstelle (152) zwischen dem ersten Busanschluss (117) und dem zweiten Busanschluss (117') bereitstellt.

4. Steuerungsvorrichtung nach Anspruch 2 oder 3, wobei mindestens ein anderes der ersten Modulteile (102) eine Breite in Längsrichtung (L) aufweist, die ein ganzzahliges Vielfaches (m) der Grundbreite (d) ist, insbesondere ein gradzahliges Vielfaches.

5. Steuerungsvorrichtung nach einem der Ansprüche 1 bis 4, wobei der weitere elektrische Kontakt (120) des ersten Modulteils (102) gegenüber dem anderen Kontaktpunkt (156) des zweiten Modulteils (104) isoliert ist.

6. Steuerungsvorrichtung nach einem der Ansprüche 1 bis 5, wobei das bewegliche Teil (150) zumindest eine elektrische Leitung (154) umfasst, die derart angeordnet ist, dass durch die elektrische Leitung (154) eine elektrische Verbindung zwischen dem ersten Kontaktpunkt (156) und dem zweiten Kontaktpunkt (158) und/oder zwischen dem ersten Busanschluss (117) und dem zweiten Busanschluss (117') bereitgestellt wird, wenn das bewegliche Teil (150) in der ersten Position ist.

7. Steuerungsvorrichtung nach einem der Ansprüche 1 bis 6, wobei die Isolierstelle (152) ein luftgefüllte Bereich ist, wenn das bewegliche Teil (150) in der zweiten Position ist.

8. Steuerungsvorrichtung nach einem der Ansprüche 1 bis 7, wobei das bewegliche Teil (150) ein auf einer Führung (164) geführtes Schiebeelement ist, das zwischen der ersten und der zweiten Position verschiebbar ist.

## Claims

1. A control apparatus (1) for the automated control of a technical installation (10), comprising a number of modules (100) which are arranged next to one another in a longitudinal direction (L), wherein the modules (100) each comprise at least one module part (104), said module part (104) being a second module part, and wherein at least one module (100) comprises said second module part (104) and furthermore a first module part (102) and a third module part (106), wherein the first module part (102) and the second module part (104) can be mechanically and electrically combined to form a first combined arrangement, wherein the first module part (102) and the third module part (106) can also be combined mechanically and electrically to form a second combined arrangement, wherein the third module part (106) comprises at least one first electrical contact (132) and the first module part (102) comprises at least one corresponding first electrical mating contact (122), which, in the second combined arrangement, makes contact with the first electrical contact (132) of the third module part (106) for electrical connection between the first module part (102) and the third module part (106), wherein the first module part (102) comprises at least one further electrical contact (120), and wherein the second module part (104) comprises at least one further electrical mating contact (130), which, in the first combined arrangement, makes contact with the further electrical contact (120) for the electrical connection between the first and second module parts (102, 104), wherein the second module part (104) further comprises a housing (105) with at least one first electrical bus connector (117) on a first side of the housing (105) for electrical connection to a first neighboring module part which is adjacent in the longitudinal direction (L), and wherein the second module part (104) furthermore comprises at least one second electrical bus connector (117') on a second side, opposite the first side, of the housing (105) for electrical connection to a second neighboring module part which is adjacent in the longitudinal direction (L), wherein the first bus connector (117) and the second bus connector (117') each are bus connectors of a supply voltage bus, which connects a supply voltage, **characterized in that** the third module part (106) furthermore comprises at least one external connector (129) for supplying a voltage from the outside, wherein the second module part (104) comprises at least one movable part (150), which is movable into a first position and a second position, wherein the movable part (150), in the first position, provides an electrical connection between the first bus connector (117) and the second bus connector (117') and, in the second position, provides an insulation point (152) between the first bus connector (117) and the second bus connector (117'), wherein the second module part (104) has a first contact point (156), which is electrically connected to the first bus connector (117'), and a second contact point (158), which is electrically connected to the second bus connector (117'), wherein the insulation point (152) is located between the first contact point (156) and the second contact point (158) when the movable part (150) is in the second position, wherein the further electrical mating contact (130) is one of the contact points (156, 158), with the result that, in the first combined arrangement, the further electrical contact (120) makes contact with one contact point (156, 158) of the second module part (104) for the electrical connection between the first and second module parts (102, 104) when the movable part (150) is in the second position in order to provide a feed connection (160), wherein the first module part (102) has its further electrical contact (120) arranged in such a way that, in the first combined arrangement, the further electrical contact (120) together with the feed connection (160) provides an electrical connection between the first and second module parts (102, 104) in order to feed a voltage from the first module part (102) to the second module part (104).

2. The control apparatus of claim 1, wherein at least one of the first module parts (102) has a basic width (d) in the longitudinal direction (L), and wherein the second module part (104) has a width in the longitudinal direction (L) which is an integer (n) multiple of the basic width (d), in particular an even-numbered multiple.

3. The control apparatus of claim 2, wherein the second module part (104) comprises a number of movable parts (150, 150a-c) which corresponds to the integer (n), which movable parts each are movable into the first position and the second position, wherein each of the movable parts (150, 150a-c) comprises an electrical line (154), which is arranged in such a way that, by virtue of the electrical lines (154), an electrical connection is provided between the first bus connector (117) and the second bus connector (117') when each of the movable parts (150, 150a-c) is in the first position, and wherein each of the movable parts (150, 150a-c) in its second position provides an insulation point (152) between the first bus connector (117) and the second bus connector (117').

4. The control apparatus of claim 2 or 3, wherein at least one other of the first module parts (102) has a width in the longitudinal direction (L) which is an integer multiple (m) of the basic width (d), in particular an even-numbered multiple.

5. The control apparatus of one of claims 1 to 4, wherein the further electrical contact (120) of the first module part (102) is insulated from the other contact point (156) of the second module part (104).

6. The control apparatus of one of claims 1 to 5, wherein the movable part (150) comprises at least one electrical line (154), which is arranged in such a way that, by virtue of the electrical line (154), an electrical connection is provided between the first contact point (156) and the second contact point (158) and/or between the first bus connector (117) and the second bus connector (117') when the movable part (150) is in the first position.

7. The control apparatus of one of claims 1 to 6, wherein the insulation point (152) is an air-filled region when the movable part (150) is in the second position.

8. The control apparatus of one of claims 1 to 7, wherein the movable part (150) is a sliding element which is guided on a guide (164) and is capable of shifting between the first and second positions.

## Revendications

1. Dispositif de commande (1) pour la commande automatisée d'une installation technique (10), avec un certain nombre de modules (100) disposés côte à côte dans une direction longitudinale (L), les modules (100) comprenant respectivement au moins une partie de module (104), la partie de module (104) étant une deuxième partie de module et au moins un module (100) comprenant la deuxième partie de module (104) et en outre une première partie de module (102) et une troisième partie de module (106), la première partie de module (102) et la deuxième partie de module (104) pouvant être rassemblées sur le plan mécanique et électrique dans un premier agencement rassemblé, la première partie de module (102) et la troisième partie de module (106) pouvant également être rassemblées sur le plan mécanique et électrique dans un deuxième agencement rassemblé, la troisième partie de module (106) comprenant au moins un premier contact électrique (132) et la première partie de module (102) comprenant au moins un premier contre-contact électrique (122) correspondant qui contacte, dans le deuxième agencement rassemblé, le premier contact électrique (132) de la troisième partie de module (106) pour établir une connexion électrique entre la première partie de module (102) et la troisième partie de module (106), la première partie de module (102) comprenant au moins un contact électrique (120) supplémentaire et la deuxième partie de module (104) comprenant au moins un contre-contact électrique (130) supplémentaire contactant, dans le premier agencement rassemblé, le contact électrique (120) supplémentaire pour établir une connexion électrique entre la première et la deuxième partie de module (102, 104), la deuxième partie de module (104) comprenant en outre un carter (105) avec au moins une première borne électrique de bus (117) au niveau d'un premier côté du carter (105) pour établir une connexion électrique avec une première partie de module voisin connexe dans la direction longitudinale (L) et la deuxième partie de module (104) comprenant en outre au moins une deuxième borne électrique de bus (117') au niveau d'un deuxième côté, opposé au premier côté, du carter (105) pour établir une connexion électrique avec une deuxième partie de module voisin connexe dans la direction longitudinale (L), la première borne de bus (117) et la deuxième borne de bus (117') étant respectivement une borne de bus d'un bus de tension d'alimentation connectant une tension d'alimentation, **caractérisé en ce que** la troisième partie de module (106) comprend en outre au moins une borne externe (129) pour appliquer une tension de l'extérieur, la deuxième partie de module (104) comprenant au moins une partie mobile (150) mobile dans une première position et une deuxième position, la partie mobile (150) mettant à disposition dans la première position une connexion électrique entre la première borne de bus (117) et la deuxième borne de bus (117') et mettant à disposition dans la deuxième position une position isolée (152) entre la première borne de bus (117) et la deuxième borne de bus (117'), la deuxième partie de module (104) comportant un premier point de contact (156) relié électriquement à la première borne de bus (117') et comportant un deuxième point de contact (158) relié électriquement à la deuxième borne de bus (117'), la position isolée (152) se trouvant entre le premier point de contact (156) et le deuxième point de contact (158) lorsque la partie mobile (150) est dans la deuxième position, le contre-contact électrique (130) supplémentaire étant un des points de contact (156, 158), de sorte que dans le premier agencement rassemblé, le contact électrique (120) supplémentaire contacte le point de contact (156, 158) de la deuxième partie de module (104) pour établir une connexion électrique entre la première et la deuxième partie de module (102, 104) lorsque la partie mobile (150) est dans la deuxième position, pour mettre à disposition une borne d'alimentation en courant (160), la première partie de module (102) ayant agencé son contact électrique (120) supplémentaire de telle sorte que dans le premier agencement rassemblé, le contact électrique (120) supplémentaire met à disposition, conjointement avec la borne d'alimentation en courant (160), une connexion électrique entre la première et la deuxième partie de module (102, 104) pour amener une tension de la première partie de module (102) à la deuxième partie de module (104).

2. Dispositif de commande selon la revendication 1, au moins une des premières parties de module (102) comporte une largeur de base (d) dans la direction longitudinale (L) et la deuxième partie de module (104) comportant une largeur dans la direction longitudinale (L) qui est un multiple à nombre entier (n) de la largeur de base (d), notamment un multiple d'un nombre de degrés.

3. Dispositif de commande selon la revendication 2, la deuxième partie de module (104) comprenant un nombre de parties mobiles (150, 150a-c) correspondant au nombre entier (n), lesdites parties mobiles étant respectivement mobiles dans la première position et la deuxième position, chacune des parties mobiles (150, 150a-c) comprenant un câble électrique (154) disposé de telle sorte qu'une connexion électrique est mise à disposition entre la première borne de bus (117) et la deuxième borne de bus (117') par le biais des câbles électriques (154) lorsque chacune des parties mobiles (150, 150a-c) est dans la première position et chacune des parties mobiles (150, 150a-c) mettant à disposition dans la deuxième position une position isolée (152) entre la première borne de bus (117) et la deuxième borne de bus (117').

4. Dispositif de commande selon la revendication 2 ou 3, au moins une autre des premières parties de module (102) comportant une largeur dans la direction longitudinale (L) étant un multiple (m) à nombre entier de la largeur de base (d), notamment un multiple à nombre de degrés.

5. Dispositif de commande selon l'une quelconque des revendications 1 à 4, le contact électrique (120) supplémentaire de la première partie de module (102) étant isolé par rapport à l'autre point de contact (156) de la deuxième partie de module (104).

6. Dispositif de commande selon l'une quelconque des revendications 1 à 5, la partie mobile (150) comprenant au moins un câble électrique (154) disposé de telle sorte qu'une connexion électrique est mise à disposition par le biais du câble électrique (154) entre le premier point de contact (156) et le deuxième point de contact (158) et/ou entre la première borne de bus (117) et la deuxième borne de bus (117') lorsque la partie mobile (150) est dans la première position.

7. Dispositif de commande salon l'une quelconque des revendications 1 à 6, la position isolée (152) étant une région remplie d'air lorsque la partie mobile (150) est dans la deuxième position.

8. Dispositif de commande selon l'une quelconque des revendications 1 à 7, la partie mobile (150) étant un élément coulissant guidé sur un guide (164), ledit élément pouvant être coulissé entre la première et la deuxième position.
